(19) Europäisches Patentamt
European Patent Office
Office européen des brevets

(11) **EP 3 690 962 A1**

(12) **EUROPÄISCHE PATENTANMELDUNG**

(43) Veröffentlichungstag:
**05.08.2020 Patentblatt 2020/32**

(51) Int Cl.:
**H01L 31/18** *(2006.01)*          **H01L 21/67** *(2006.01)*

(21) Anmeldenummer: **19154936.9**

(22) Anmeldetag: **31.01.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **(CNBM) Bengbu Design & Research Institute for
Glass Industry Co., Ltd.
233010 Bengbu (CN)**

(72) Erfinder: **Die Erfindernennung liegt noch nicht vor**

(74) Vertreter: **Gebauer, Dieter Edmund
Splanemann
Patentanwälte Partnerschaft
Rumfordstraße 7
80469 München (DE)**

(54) **ANORDNUNG, VORRICHTUNG UND VERFAHREN ZUM WÄRMEBEHANDELN EINES MEHRSCHICHTKÖRPERS**

(57) Die Erfindung betrifft eine Anordnung (102) zum Wärmebehandeln eines Mehrschichtkörpers (1), welche eine Energiequelle (16, 7, 11) mit mindestens einem Heizstrahler zur Erzeugung einer Heizstrahlung (6, 8), einen Mehrschichtkörper (1), und ein zwischen der Energiequelle (16, 7, 11) und dem Mehrschichtkörper (1) angeordnetes Zwischenelement (15, 5, 12) umfasst. Gemäß einer ersten Alternative umfasst das Zwischenelement (15, 5, 12) ein in Form einer biegsamen Folie (18) ausgebildetes Flächenelement (17). Gemäß einer zweiten Alternative umfasst das Zwischenelement (15, 5, 12) ein in Form einer biegsamen Folie (18) oder starren Platte (19) ausgebildetes Flächenelement (17), wobei das Flächenelement (17) eine der Energiequelle (16, 7, 11) zugewandte Fläche (27) aufweist, die von der Heizstrahlung (6, 8) bestrahlt werden kann, wobei die der Energiequelle (16, 7, 11) zugewandte Fläche (27) durch eine Stützeinrichtung (22, 23, 25, 26) in Richtung zur Energiequelle (16, 7, 11) mechanisch abgestützt ist.

FIG. 2

EP 3 690 962 A1

**Beschreibung**

Die vorliegende Erfindung liegt auf dem technischen Gebiet der Herstellung von Dünnschichtsolarmodulen und betrifft eine Anordnung, eine Vorrichtung und ein Verfahren zur thermischen Behandlung eines Mehrschichtkörpers für ein Dünnschichtsolarmodul.

Photovoltaische Schichtensysteme für die Fertigung von Dünnschichtsolarmodulen sind dem Fachmann wohlbekannt. Die Materialien der Schichten, insbesondere das halbleitende Material der zur photoelektrischen Konversion eingesetzten Absorberschicht, werden so gewählt, dass das einfallende Sonnenlicht mit einem zufriedenstellenden Wirkungsgrad in elektrischen Strom umgewandelt werden kann. Aufgrund der physikalischen Eigenschaften und der technologischen Handhabbarkeit sind Absorberschichten aus amorphem, mikromorphem oder polykristallinem Silizium, Cadmium-Tellurid (CdTe), Gallium-Arsenid (GaAs), Kupfer-Indium/Gallium-Diselenid/Disulfid/Disulfoselenid (Cu(In,Ga) $(S,Se)_2$), Kupfer-Zink-Zinn-Sulfo-Selenid (CZTS aus der Gruppe der Kesterite) und organischen Halbleitern in besonderer Weise geeignet. Der pentenäre Halbleiter Cu(In,Ga) $(S,Se)_2$, der zur Gruppe der Chalkopyrit-Verbindungshalbleiter gehört, hat in der industriellen Serienenfertigung von Dünnschichtsolarmodulen besondere Bedeutung erlangt.

Ein mögliches Verfahren zur Herstellung von Absorberschichten aus Cu(In,Ga)$(S,Se)_2$ besteht aus einem Zweistufenprozess. Solche zweistufigen Verfahren sind beispielsweise aus J. Palm et al., "CIS module pilot processing applying concurrent rapid selenization and sulfurization of large area thin film precursors", Thin Solid Films 431-432, S. 414-522 (2003) bekannt. Hierbei wird in einer ersten Stufe ein Precursor abgeschieden, der in einer zweiten Stufe wärmebehandelt wird. Durch die Wärmebehandlung (RTP = Rapid Thermal Processing) erfolgt die Kristallbildung und Phasenumwandlung des Precursors zur Halbleiterschicht.

Die Wärmebehandlung des beschichteten Substrats erfolgt beispielsweise in In-Line-Anlagen, bei denen das beschichtete Substrat nacheinander verschiedenen Kammern zugeführt wird, die entlang einer Prozessstraße angeordnet sind. In einem typischen Aufbau umfasst eine solche In-Line-Anlage eine Ladestation, Heizkammern, in denen die beschichteten Substrate mit Aufheizgeschwindigkeiten von mehreren °C/s schnell erwärmt werden, sowie Kühlkammern, in denen die beschichteten Substrate abgekühlt und aus der Anlage ausgeschleust werden.

Die Wärmebehandlung des beschichteten Substrats ist ein kostenintensiver und technisch anspruchsvoller Prozess, der hohe Temperaturen, einen genauen Temperaturverlauf und eine definierte Zusammensetzung der Prozessatmosphäre erfordert, wenn hohe Wirkungsgrade mit ausreichend guter Reproduzierbarkeit erreicht werden sollen. So müssen beispielsweise bei der Fertigung hochwertiger Cu(In,Ga) $(S,Se)_2$-Verbindungshalbleiter der Dampfdruck und die Stoffmenge Selens (Se) in der Prozessatmosphäre gut kontrolliert werden. Eine ausreichende Se-Menge ist nötig, um eine vollständige Selenisierung des metallischen Precursors zu gewährleisten. Deutlicher Se-Verlust würde zu einer unvollständigen Umwandlung des Precursors zum Verbindungshalbleiter führen. Selbst ein schwacher Se-Verlust kann noch zu Rekombination, d.h. Wirkungsgradverlust, und verstärkten Transienten (insbesondere Damp-Heat-Verluste) im fertigen Dünnschichtsolarmodul führen.

Zur besseren Kontrolle der Parameter des Wärmebehandlungsprozesses ist es bekannt, den Prozessraum für das beschichtete Substrat durch eine Prozessbox zu begrenzen. Hierdurch kann der Partialdruck der leicht flüchtigen Chalkogenkomponenten wie Selen oder Schwefel während der Wärmebehandlung weitestgehend konstant gehalten werden. Außerdem wird die Exposition der Prozesskammer mit korrosiven Gasen reduziert. Selen und Schwefel sind äußerst korrosive Stoffe, die Metalle bei den bei der Wärmebehandlung erforderlichen hohen Temperaturen stark angreifen.

Die Erwärmung des beschichteten Substrats erfolgt typischer Weise durch elektrisch betriebene Heizstrahler, die deckel- und bodenseitig der Prozessbox angeordnet sind, wobei die Heizstrahlung (sichtbares Licht bis Infrarot) auf Deckel und Boden der Prozessbox gerichtet ist. Für Deckel und Boden haben sich Glaskeramikplatten bewährt, da sie hochtemperaturfest, unempfindlich gegenüber Temperaturgradienten und inert gegenüber Korrosion durch Selen oder Schwefel sind, einen sehr niedrigen Ausdehnungskoeffizienten aufweisen und eine hohe mechanische Stabilität besitzen. Der Rahmen besteht typischer Weise aus Graphit oder einem Verbundwerkstoff wie ein kohlenstofffaserverstärkter Kohlenstoff (CFRC = Carbon-Fiber-Reinforced Carbon, RCC = Reinforced Carbon-Carbon, CFC = Carbon Fiber Carbon Composite).

Die Verwendung einer Prozessbox erlaubt zwar eine zuverlässige Herstellung qualitativ hochwertiger Absorberschichten, jedoch ist der Energieverbrauch bei diesem Herstellungsprozess relativ hoch, da nicht nur das beschichtete Substrat, sondern auch die Prozessbox erwärmt wird. Mit jeweils 4 mm dicken Platten für Boden und Deckel beträgt allein deren Masse jeweils bereits etwa das Vierfache des beschichteten Substrats. Bei einem Substrat mit einer Größe von etwa 1 m$^2$ (entspricht 5 kg bei 2 mm Dicke) beträgt das Gesamtgewicht der Prozessbox mit Rahmen ca 40 kg. Diese Masse wird während der thermischen Umsetzung des Precursors bis auf Prozesstemperatur aufgeheizt und muss anschließend wieder abgekühlt werden. Dies ist nachteilig, da es für eine nachhaltige und kostengünstige Herstellungsweise von Dünnschichtsolarmodulen wünschenswert ist, den Energieverbrauch so niedrig wie möglich zu halten.

Zudem müssen generelle Anforderungen an eine Prozessbox erfüllt sein, nämlich ein schneller Energieeintrag in den Innenraum, der Heizraten des Precursors von mehreren °C/s erlaubt, sowie eine ausreichende mechanische Robustheit, um den Transport eines beschichteten Substrats (typischer Weise ca. 5 kg/m$^2$) zu gewährleisten und leichte Über- oder Unterdrücke während Spül- und Abpumpprozesse und während der konvektiven Kühlung auszuhalten. Die mechanischen Belastungen liegen hierbei in der Größenordnung von bis zu 40 kg/m$^2$ (ohne Eigengewicht). Die Belastungen erfordern insbesondere eine hohe Biegezugfestigkeit des eingesetzten Materials. Des Weiteren muss die Prozessbox hinreichend mechanisch steif sein, so dass sich das Volumen des Prozessraums nicht signifikant ändert, beispielsweise durch elastische oder plastische Verformung während der Wärmebehandlung des beschichteten Substrats.

Die vorliegende Erfindung zielt auf vorstehende Aufgaben ab, wobei die im Stand der Technik bekannten Vorrichtungen zum Wärmebehandeln beschichteter Substrate in vorteilhafter Weise so weitergebildet werden sollen, dass eine energiesparende und kostengünstige Herstellung von Dünnschichtsolarmodulen in zuverlässiger Weise mit reproduzierbaren hohen Wirkungsgaden ermöglicht ist.

Diese und weitere Aufgaben werden nach dem Vorschlag der Erfindung durch eine Anordnung, eine Vorrichtung und ein Verfahren zum Wärmebehandeln eines Mehrschichtkörpers mit den Merkmalen der unabhängigen und nebengeordneten Ansprüche gelöst. Bevorzugte Ausführungen gehen aus den Unteransprüchen hervor.

Erfindungsgemäß ist eine Anordnung und eine Vorrichtung zum Wärmebehandeln eines Mehrschichtkörpers gezeigt. Der Ausdruck "Mehrschichtkörper" beschreibt im Sinne der Erfindung ein Substrat, z.B. ein Glassubstrat, mit einer oder mehreren darauf aufgebrachten Schichten, die einer Wärmebehandlung zu unterziehen sind.

Der Mehrschichtkörper dient zur Herstellung eines Dünnschichtsolarmoduls. Vorzugsweise handelt es sich um ein Dünnschichtsolarmodul mit Verbundscheibenstruktur, welches über eine Deckplatte und ein rückseitiges Substrat (z.B. Glasplatten) verfügt, die durch eine thermoplastische oder vernetzende Polymer-Zwischenschicht (z.B. PVB oder EVA) fest miteinander verbunden sind. Die Erfindung bezieht sich insbesondere auf einen Mehrschichtkörper für ein Dünnschichtsolarmodul in Substratkonfiguration, bei der der Schichtenaufbau zur Herstellung der Solarzellen auf einer der Lichteintrittsseite zugewandten Oberfläche des rückseitigen Substrats aufgebracht ist, oder in Superstratkonfiguration, bei welcher der Schichtenaufbau auf einer von der Lichteintrittsseite abgewandten Oberfläche der transparenten Deckplatte aufgebracht ist.

In Einklang mit der üblichen Verwendung bezieht sich der Begriff "Dünnschichtsolarmodul" auf Module mit einem Schichtenaufbau mit einer geringen Dicke von beispielsweise einigen Mikrometern, welche einen Träger für eine ausreichende mechanische Festigkeit benötigen. Der Träger kann beispielsweise aus Glas, Kunststoff, Metall oder einer Metalllegierung bestehen und in Abhängigkeit von der jeweiligen Schichtdicke und den spezifischen Materialeigenschaften als starre Platte oder biegsame Folie ausgestaltet sein.

Bei einem Dünnschichtsolarmodul umfasst der Schichtenaufbau in an sich bekannter Weise eine Rückelektrodenschicht, eine Frontelektrodenschicht, und eine zwischen Rück- und Frontelektrodenschicht angeordnete, fotovoltaisch aktive Absorberschicht. Die Frontelektrodenschicht ist optisch transparent, da ein Durchtritt von Licht zum Schichtenaufbau ermöglicht sein muss. Die Frontelektrodenschicht umfasst oder besteht typischer Weise aus einem dotierten Metalloxid (TCO = Transparent Conductive Oxide), beispielsweise n-leitendes, insbesondere Aluminium-dotiertes, Zinkoxid (AZO).

Vorzugsweise weist der Mehrschichtkörper einen Schichtenstapel (Precursor) zur Herstellung eines chalkogenhaltiges Halbleitermaterials auf. Als Chalkogene werden die Elemente der 6. Hauptgruppe des Periodensystems bezeichnet. Das Halbleitermaterial der Absorberschicht enthält mindestens ein Chalkogen, vorzugsweise Schwefel und/oder Selen. Besonders bevorzugt ist dies ein chalkogenhaltiger Chalkopyrit-Verbindungshalbleiter, bei dem es sich vorteilhaft um einen ternären I-III-VI-Verbindungshalbleiter aus der Gruppe Kupfer-Indium/Gallium-Disulfid/Diselenid handelt, abgekürzt durch die Formel $Cu(In,Ga)(S,Se)_2$. In vorstehender Formel können Indium und Gallium jeweils allein oder in Kombination vorliegen. Entsprechendes gilt für die Chalkogene Schwefel und Selen, die jeweils allein oder in Kombination vorliegen können. Als Material für die Absorberschicht eignet sich in besonderer Weise CISe (Kupfer-Indium-Diselenid), CIS (Kupfer-Indium-Disulfid), CIGSe (Kupfer-Indium-Gallium-Diselenid) CIGS (Kupfer-Indium-Gallium-Disulfid) oder CIGS-Se (Kupfer-Indium-Gallium-Disulfoselenid). Gleichermaßen bevorzugt kann der Mehrschichtkörper einen Schichtenstapel (Precursor) zur Herstellung eines chalkogenhaltigen Kesterit-Verbindungshalbleiters, vorzugsweise Kupfer-Zink-Zinn-Sulfoselenid (CZTS) aufweisen. Der chalkogenhaltige Kesterit-Verbindungshalbleiter enthält mindestens ein Chalkogen, vorzugsweise Schwefel und/oder Selen.

Zweckmäßig wird eine $Cu(In,Ga)(S,Se)_2$-Absorberschicht auf einem Substrat in einem zweistufigen RTP-Prozess hergestellt. Hierbei wird, nach Herstellen einer Rückelektrodenschicht auf dem Substrat, zunächst eine Vorläuferschicht (Precursor) auf die Rückelektrodenschicht aufgebracht. Die Vorläuferschicht, welche aus einer oder mehreren Lagen bestehen kann, enthält die Elemente Kupfer, Indium und Gallium, die vorzugsweise durch Sputtern aufgebracht werden. Des Weiteren enthält die Vorläuferschicht mindestens ein Chalkogen in elementarer Form, vorzugsweise Selen und/oder Schwefel, welches vorzugsweise durch thermisches Verdampfen aufgebracht wird. Bei diesen Abscheideprozessen liegt die Temperatur des Trägers typischer Weise unterhalb von 100 °C, so dass die Elemente im Wesentlichen als Metalllegierung und elementares Chalkogen (Selen und/oder Schwefel) unreagiert erhalten bleiben. Anschließend wird die Vorläuferschicht durch Erwärmen in einer mindestens ein Chalkogen (Selen und/oder Schwefel) enthaltenden Atmosphäre zu einem Cu(In,Ga) $(S,Se)_2$-Verbindungshalbleiter reagiert (thermisch umgesetzt). Beispielsweise enthält die Vorläuferschicht als Chalkogen nur elementares Selen und die thermische Umsetzung der Vorläuferschicht erfolgt in einer Atmosphäre, die als Chalkogen nur Schwefel enthält. Durch die Wärmebehandlung der Vorläuferschicht findet eine Kristallbildung und Phasenumwandlung der Vorläuferschicht zur Halbleiterschicht (Verbindungshalbleiter) statt. In entsprechender Weise kann in einem zweistufigen Verfahren ein chalkogenhaltiger Kesterit-Verbindungshalbleiter hergestellt werden, wobei zunächst eine Vorläuferschicht auf die Rückelektrodenschicht aufgebracht wird, die Kupfer, Zink, Zinn und mindestens ein Chalkogen (vorzugsweise Schwefel und/oder Selen, besonders bevorzugt nur Selen) enthält. Anschließend wird die Vorläuferschicht durch Erwärmen in einer Atmosphäre, welche mindestens ein Chalkogen (vorzugsweise Schwefel und/oder Selen, besonders bevorzugt nur Schwefel) enthält, zum Verbindungshalbleiter umgesetzt.

Die erfindungsgemäße Anordnung zum Wärmebehandeln eines Mehrschichtkörpers umfasst eine Energiequelle mit mindestens einem Heizstrahler (z.B. ein Strahlerfeld mit einer ein- oder zweidimensionalen Anordnung von Heizstrahlern) zur Erzeugung einer Heizstrahlung, einen Mehrschichtkörper, sowie ein zwischen der Energiequelle und dem Mehrschichtkörper angeordnetes Zwischenelement, auf welches die Heizstrahlung trifft.

Gemäß einer ersten Alternative umfasst das Zwischenelement ein in Form einer biegsamen Folie ausgebildetes Flächenelement. Gemäß einer zweiten Alternative umfasst das Zwischenelement ein Flächenelement, dass in Form einer biegsamen Folie oder einer starren Platte ausgebildet ist, wobei auf einer der Energiequelle zugewandten Seite des Flächenelements eine Stützeinrichtung zum mechanischen Abstützen des Flächenelements in Richtung zur Energiequelle angeordnet ist. Konkret wird eine der Energiequelle zugewandte Fläche des Flächenelements, welche von der Heizstrahlung der Energiequelle bestrahlt werden kann, von der Stützeinrichtung in Richtung der Energiequelle mechanisch abgestützt. Beispielsweise besteht das Zwischenelement nur aus dem Flächenelement oder setzt sich aus dem Flächenelement und der Stützeinrichtung zusammen.

Im Sinne vorliegender Erfindung bezeichnet der Begriff "Flächenelement" einen flächig-ebenen Körper, beispielsweise mit Rechteckform. Das Flächenelement weist eine der Energiequelle zugewandte erste Fläche auf, die von der Heizstrahlung der Energiequelle direkt bestrahlt werden kann. Die von der Heizstrahlung direkt bestrahlte Fläche kann der ersten Fläche des Flächenelements entsprechen, aber auch kleiner sein. Gegenüberliegend zur ersten Fläche weist das Flächenelement eine von der Energiequelle abgewandte zweite Fläche auf, welche bei der Verwendung des Zwischenelements als Boden auch als Auflagefläche für den Mehrschichtkörper dienen kann.

In der erfindungsgemäßen Anordnung zum Wärmebehandeln eines Mehrschichtkörpers sind die Energiequelle und das Zwischenelement so angeordnet, dass der Mehrschichtkörper direkt durch Heizstrahlung (bei einem für die Heizstrahlung transparenten oder teiltransparenten Flächenelement) oder indirekt durch das aufgeheizte Flächenelement (bei einem für die Heizstrahlung opaken Flächenelement) aufgeheizt werden kann. Bei direkter Aufheizung passiert zumindest ein Teil der Heizstrahlung der Energiequelle das Flächenelement und trifft auf den Mehrschichtkörper, wodurch der Mehrschichtkörper aufgeheizt wird. Bei indirekter Aufheizung wird das Flächenelement durch die auftreffende Heizstrahlung der Energiequelle aufgeheizt und gibt die Wärme über Wärmestrahlung und Wärmeleitung an den Mehrschichtkörper ab. Falls das Flächenelement opak ist, erfolgt eine Heizung des Mehrschichtkörpers im Wesentlichen indirekt durch das erwärmte Flächenelement mittels Wärmestrahlung und Wärmeleitung. Das Flächenelement hat vorzugsweise eine geringe Reflektivität und eine hohe Emissivität, damit die vom Strahlerfeld emittierte Strahlung weitestgehend absorbiert wird.

Im Sinne vorliegender Erfindung bezieht sich der Begriff "Transparenz" bzw. "transparent" auf eine Durchlässigkeit für Heizstrahlung von wenigstens 85%, insbesondere wenigstens 90%, vorzugsweise wenigstens 95%, insbesondere 100%. Der Begriff "Opazität" bzw. "opak" bezieht sich auf eine Durchlässigkeit für Heizstrahlung von weniger als 5%, insbesondere 0%. Der Begriff "Teiltransparenz" bzw. "teiltransparent" bezieht sich auf eine Durchlässigkeit für Heizstrahlung die zwischen jener der Opazität und Transparenz liegt.

Das Flächenelement ist gemäß der ersten Alternative als biegsame Folie ausgebildet oder gemäß der zweiten Alternative als biegsame Folie oder dünne starre Platte mit mechanischer Stützeinrichtung ausgebildet. Erfindungsgemäß kann das Zwischenelement so ausgebildet sein, dass es eine geringere Masse aufweist als im Stand der Technik eingesetzte Zwischenelemente, was in vorteilhafter Weise eine erhebliche Einsparung von Energiekosten bei der Wärmebehandlung des Mehrschichtkörpers ermöglicht. Da das Flächenelement sehr dünn ausgebildet sein kann, sind zudem auch opake Materialen für das Flächenelement verwendbar, da die gewünschten hohen Heizraten von einigen °C pro Sekunde nur mit sehr dünnen Flächenelementen erreicht werden können.

Vorzugsweise weist das Flächenelement eine solche (geringe) Dicke auf, dass ein Formfaktor, gegeben durch den Quotienten aus Dicke/Diagonale des Flächenelements, weniger als 4 mm/1 m, also weniger als $4 \times 10^{-3}$, beträgt. Hier wird ein rechteckförmiges Flächenelement mit einer Diagonalen der der Energiequelle zugewandten ersten Fläche betrachtet. Vorzugsweise weist das Flächenelement eine solche Dicke auf, dass der Formfaktor weniger als 5 x 10⁻⁴ beträgt. Dies gilt insbesondere für den Fall, dass die Transmission des Flächenelements weniger als 20%, weniger als 5% oder weniger als 1% ist, was schnelle Heizraten des Mehrschichtkörpers ermöglicht. Ist die Transmission des Flächenelements größer als 50% oder sogar größer als 70%, kann der Formfaktor auch größer sein.

Vorzugsweise beträgt die Dicke des Flächenelements weniger als 4 mm, stärker bevorzugt weniger als 1 mm, noch stärker bevorzugt weniger als 0,5 mm.

Vorzugsweise ist die gesamte Masse des Zwischenelements so gewählt, dass sie weniger als 400%, vorzugsweise weniger als 200%, stärker bevorzugt weniger als 100%, noch stärker bevorzugt weniger als 50%, am stärksten bevorzugt weniger als 10%, der Masse des Mehrschichtkörpers beträgt. Hierdurch können bei der Wärmebehandlung des Mehrschichtkörpers Energiekosten in erheblichen Umfang eingespart werden.

Falls das Flächenelement in Form einer nicht formstabilen, d.h. biegsamen, Folie ausgebildet ist, beträgt die Dicke der Folie vorzugsweise weniger als 0,5 mm, stärker bevorzugt weniger als 0,3 mm.

Vorzugsweise enthält oder besteht die Folie aus Graphit mit oder ohne Korrosionsinhibitor, welche reißfest und korrosionsbeständig ist. Vorzugsweise enthält oder besteht die Folie aus einem Verbundwerkstoff, wie beispielsweise ein kohlenstofffaserverstärkter Kohlenstoff. Möglich ist auch, dass die Folie eine ein- oder beidseitig mit einer Korrosionsschutzschicht beschichtete Metallfolie ist. Die Beschichtung der Metallfolie ist hierdurch resistent gegen Korrosion bei hohen Temperaturen. Ein Beispiel hierfür ist eine Molybdän-Folie, die beidseitig mit einer z.B. 20 bis 1000 nm dicken Molybdän-Nitrid (MoN)-Schicht beschichtet ist, die als Korrosionsschutzschicht dient. Möglich sind auch andere keramische Korrosionsschutzschichten, beispielsweise aus SiC, $Al_2O_3$, TiN usw. Metallfolien sind mechanisch sehr stabil hinsichtlich Biegezugfestigkeit und Reißfestigkeit. Sie können deshalb sehr dünn sein. Die hohe Wärmeleitfähigkeit sorgt für eine homogene Temperaturverteilung. Die Emissivität der Metallfolien sollte durch deren Beschichtung oder Oberflächenrauigkeit möglichst hoch sein und der Reflexionsgrad sehr gering. Die Korrosionsbeständigkeit wird durch die Korrosionsschutzschicht gewährleistet.

Alternativ zu beschichteten Metallfolien sind auch Verbundfolien geeignet, beispielsweise eine Metallfolie, die durch einen Klebstoff (z.B. ein keramischer Klebstoff oder Graphitkleber) ein- oder beidseitig mit einer Graphitfolie verbunden ist. Die Funktion der Abdichtung und der Korrosionsstabilität übernimmt die Graphitfolie. Die mechanische Stabilität wird durch die Metallfolie erreicht.

Falls das Flächenelement in Form einer starren Platte ausgebildet ist, beträgt die Dicke der Platte vorzugsweise weniger als 4 mm, stärker bevorzugt weniger als 1 mm, noch stärker bevorzugt weniger als 0,5 mm. Vorzugsweise enthält oder besteht die Platte aus Glaskeramik, kohlenstofffaserverstärkter Kohlenstoff oder einem Glas mit einem hohen Erweichungspunkt (typischer Weise höher als 800°C) wie Borosilikatglas, Aluminiumsilikatglas oder Quarzglas.

Das in Form einer biegsamen Folie oder starren Platte ausgebildete Flächenelement hat vorzugsweise eine geringe Reflektivität und hohe Emissivität, damit die von der Energiequelle emittierte Strahlung weitestgehend absorbiert wird. Vorzugsweise hat das Flächenelement zur Energiequelle hin eine Reflexion von kleiner 10%, stärker bevorzugt kleiner 5% und am besten kleiner 2% (die prozentualen Angaben beziehen sich auf den Anteil der reflektierten Heizstrahlung).

Die zweite Fläche des in Form einer biegsamen Folie oder starren Platte ausgebildeten Flächenelements, die als Auflagefläche für einen Mehrschichtkörper dienen kann, ist vorzugsweise mit Erhebungen strukturiert, so dass die Kontaktfläche zum Mehrschichtkörper möglichst gering ist. Damit wird der Einfluss der Wärmeleitung unterdrückt. Die Wärmeleitung kann zu einem räumlich sehr inhomogenen Aufheizen führen, wenn sich der Mehrschichtkörper beim Aufheizen wölbt oder schon durch Vorprozesse nicht ganz plan ist. Die Strukturierung kann durch Aufrauen, lokale Entschichtung oder Beschichtung erfolgen. Die Strukturierung umfasst Erhebungen, die als statistische und/oder periodische Strukturen ausgebildet sein können, deren Abmessung senkrecht zum Flächenelement (Höhe) vorzugsweise im Bereich von einem bis mehreren Hundert Mikrometern liegt.

Die Stützeinrichtung ist so ausgebildet, dass sie das Flächenelement bzw. die erste Fläche des Flächenelements in Richtung zur Energiequelle hin mechanisch abstützt. Die Stützeinrichtung ist zu diesem Zweck zwischen dem Flächenelement und der Energiequelle angeordnet. Die Stützeinrichtung stützt das Flächenelement vorzugsweise nicht vollflächig ab, d.h. eine Kontaktfläche der Stützeinrichtung, in dem die Stützeinrichtung Berührungskontakt mit der ersten Fläche hat, ist kleiner als die erste Fläche. Insbesondere ist die Stützeinrichtung somit nicht in Form einer Schicht oder Beschichtung ausgebildet, welche auf die erste Fläche des Flächenelements aufgebracht ist. Vorzugsweise bedeckt die Stützeinrichtung weniger als 10% der ersten Fläche des Flächenelements (in Sicht senkrecht durch das Flächenelement), so dass nur eine geringfügige Abschattung der auf das Flächenelement auftreffenden Heizstrahlung durch die Stützeinrichtung erfolgt. Der Mehrschichtkörper kann somit homogen aufgeheizt werden und es treten nur geringe thermische Inhomogenitäten auf. Beispielsweise haben das Flächenelement und die Stützeinrichtung nur losen Berührungskontakt, wobei die Stützeinrichtung der ersten Fläche des Flächenelements anliegt. Vorzugsweise sind das Flächenelement und die Stützeinrichtung fest miteinander verbunden. Beispielsweise ist die Stützeinrichtung mit der ersten Fläche des Flächenelements fest verbunden, beispielsweise durch einen Klebstoff, vorzugsweise durch einen keramischen Klebstoff. Vorzugsweise ist die Stützeinrichtung nur stellenweise, insbesondere punktweise, mit dem Flächenelement fest verbunden, um einen unerwünschten Wärmeübergang (Kältebrücken) zu minimieren.

Die Kombination von Flächenelement und Stützeinrichtung ermöglicht gleichsam eine Entkopplung der Anforderungen an das Zwischenelement einerseits einen gasdichten Prozessraum mit geringer Masse zu formen und andererseits ausreichend mechanisch stabil sowie genügend beständig gegen die bei der Wärmebehandlung auftretenden korrosiven Substanzen zu sein. Insbesondere kann das Flächenelement hiebei gezielt im Hinblick auf die gasdichte Ausbildung des Prozessraums bei geringer Masse und Korrosionbeständigkeit optimiert werden, wobei durch die Stützeinrichtung eine ausreichende mechanische Stabilität gewährleistet wird.

Gemäß einer bevorzugten Ausgestaltung der Erfindung ist die Stützeinrichtung in Form eines Gitters aus sich kreuzenden linienförmigen Stützelementen ausgebildet. Das Gitter weist eine oder vorzugsweise eine Vielzahl von Maschen auf. Vorteilhaft sind die linienförmigen Stützelemente im Gitter fest miteinander verbunden. Gemäß einer weiteren bevorzugten Ausgestaltung sind die linienförmigen Stützelemente in einer Linienanordnung angeordnet, wobei die linienförmigen Stützelemente nebeneinander liegend, insbesondere parallel, angeordnet sind. Durch die Stützeinrichtung kann einerseits eine gute mechanische Abstützung des Flächenelements erreicht werden. Andererseits sind Inhomogenitäten beim Aufheizen des Mehrschichtkörpers durch Abschirmen der Heizstrahlung relativ gering. Vorteilhaft erstreckt sich das Gitter bzw. die Linienanordnung über die komplette erste Fläche des Flächenelements (in senkrechter Sicht durch das Flächenelement), ohne jedoch Berührungskontakt mit der kompletten ersten Fläche zu haben.

In Abhängigkeit der Dicke der linienförmigen Stützelemente kann deren Zahl im Hinblick auf die für die mechanische Abstützung geforderte Kraftaufnahme geeignet gewählt sein, wobei entweder eine geringere Zahl von dickeren Stützelementen oder eine größere Zahl von dünneren Stützelementen vorgesehen sein können. Je dünner die linienförmigen Stützelemente sind, desto geringer sind die hierdurch verursachten möglichen Abschattungen und Temperaturinhomogenitäten. Das in Form einer Folie oder dünnen Platte ausgebildete Flächenelement kann z.B. durch einen keramischen Kleber mit den linienförmigen Stützelementen verbunden sein.

Vorteilhaft ist das Gitter aus linienförmigen Stützelementen ein Draht- oder Stabgitter, wobei die linienförmigen Stützelemente aus Metall oder einem anderen Material bestehen können. Optional bestehen die linienförmigen Stützelemente aus Metall, das mit einer Korrosionsschutzschicht beschichtet ist. Beispielsweise enthalten oder bestehen die Metalldrähte aus einer Molybdän- oder Wolfram-Legierung. Beispielsweise enthält oder besteht die keramische Korrosionsschutzschicht aus $Al_2O_3$, $MoN$, $Si_3N_4$ oder dergleichen. Möglich wäre auch eine Herstellung des (Draht-)Gitters aus Glasfasern. Die linienförmigen Stützelemente können beispielsweise aus Graphit, Metall, Keramik, Glaskeramik oder einem Glas mit einem hohen Erweichungspunkt (typischer Weise oberhalb von 800°C), wie Borosilikatglas, Aluminosilikatglas oder Quarzglas, bestehen. Sie können auch aus einem Verbundwerkstoff wie kohlenstofffaserverstärkter Kohlenstoff gefertigt sein.

Die linienförmigen Stützelemente sind vorzugsweise als Drähte oder Stäbe ausgebildet. In Einklang mit der gängigen Verwendung der Begriffe unterscheiden sich Stäbe nur durch ihren größeren Querschnitt von Drähten.

Der Querschnitt der linienförmigen Stützelemente ist vorzugsweise rund (kreis- bzw. scheibenförmig) oder rechteckig. Bei linienförmigen Stützelementen in Rechteckform (Stäbe) ist es bevorzugt, wenn die schmälere Fläche parallel zum Flächenelement (erste Fläche) liegt. Durch einen rechteckigen Querschnitt mit der schmäleren Seite parallel zum Flächenelement wird eine hohe Steifigkeit bei reduzierter Verschattung erreicht. Je nach Material und Konstruktion kann der Querschnitt der linienförmigen Stützelemente kreisförmig (Runddraht bzw. Rundstab), ringförmig (Rohr), T-förmig (T-Träger) oder Doppel-T-förmig (Doppel-T-Träger) sein.

Die linienförmigen Stützelemente können opak, teiltransparent oder transparent sein. Bevorzugt sind die linienförmigen Stützelemente mindestens teiltransparent, d.h. teiltransparent oder transparent. Vorteilhaft beträgt die Absorption der Heizstrahlung in den linienförmigen Stützelementen weniger als 50%, stärker bevorzugt weniger als 20% und ist am besten kleiner als 5%. Durch die Transparenz ist die Abschattung der Heizstrahlung auf die Fläche des Flächenelements (Folie oder dünne Platte) sehr gering.

Da sich linienförmige Stützelemente aufgrund einer vergleichsweise großen Masse langsamer aufheizen können als das Flächenelement selbst und insbesondere opake Stäbe auch ein gewisse Verschattung bewirken, ist es vorteilhaft, zwischen die linienförmigen Stützelemente und das Flächenelement einen thermischen Isolator einzubauen. So kann verhindert werden, dass die Verbindungsstelle als Wärmesenke wirkt. Dies könnte zu Inhomogenitäten im Strahlungsfeld und damit möglicherweise auch im Mehrschichtkörper führen. Dies ist vorteilhaft ein keramischer Kleber. Die Befestigung erfolgt vorzugsweise punktförmig zur Reduzierung von Kältebrücken.

Die Erfindung betrifft weiterhin eine Vorrichtung zum Wärmebehandeln eines Mehrschichtkörpers, welche mindestens eine wie vorstehend beschrieben ausgebildete Anordnung zum Wärmebehandeln eines Mehrschichtkörpers umfasst.

Die Vorrichtung zum Wärmebehandeln eines Mehrschichtkörpers umfasst eine Einrichtung zum Ausbilden eines (reduzierten) Prozessraums für einen Mehrschichtkörper. Der Prozessraum ist in Bezug auf das Kammervolumen einer Kammer (Heiz- oder Kühlkammer), in dem sich die Einrichtung zum Ausbilden eines reduzierten Prozessraums befindet, reduziert. Die Einrichtung zum Ausbilden eines Prozessraums umfasst einen bodenseitigen Abschnitt, im Weiteren als "Boden" bezeichnet, einen deckelseitigen Abschnitt, im Weiteren als "Deckel" bezeichnet, sowie mindestens einen Rahmen, die gemeinsam einen zumindest während der Wärmebehandlung gasdichten Prozessraum zur Aufnahme des Mehrschichtkörpers bilden. Der Rahmen verbindet Boden und Deckel miteinander und dient gleichzeitig als Abstandshalter für Deckel und Boden. Der Rahmen besteht beispielsweise aus Graphit oder einem Verbundwerkstoff wie ein kohlenstofffaserverstärkter Kohlenstoff.

Im Sinne vorliegender Erfindung bedeutet "Gasdichtigkeit", dass der Prozessraum nicht zwingend geschlossen sein muss. Vielmehr kann der Prozessraum auch eine oder mehrere Öffnungen zur äußeren Umgebung aufweisen, solange ein Gasaustausch zwischen Prozessraum und äußerer Umgebung während der Wärmebehandlung eines Mehrschichtkörpers so gering ist, dass die Atmosphäre im Prozessraum hierdurch nicht wesentlich beeinträchtigt wird. Dies gilt für den bei der Wärmebehandlung üblicher Weise vorherrschenden Normaldruck. Wird hingegen ein Über- oder Unterdruck angelegt, ist der Gasaustausch nicht mehr vernachlässigbar.

Im Prozessraum ist bzw. kann ein Mehrschichtkörper aufgenommen werden. Der Deckel und der Boden sind jeweils flächig-ebene Abschnitte der Einrichtung zum Ausbilden eines Prozessraums, beispielsweise in Rechteckform, die in Arbeitsposition mit ihren Ebenen typischer Weise parallel zur Horizontalen angeordnet sind. Der Rahmen ist typischer Weise umlaufend zum Boden bzw. Deckel angeordnet. Die Rahmenwand ist typischer Weise senkrecht zur Horizontalen gerichtet. Vorzugsweise ist der Mehrschichtkörper auf dem Boden gelagert.

Der Rahmen kann mit dem Deckel fest verbunden sein und wird dann als "Deckelrahmen" bezeichnet. In diesem Fall ist der Rahmen mit dem Boden nicht fest verbunden. Alternativ kann der Rahmen mit dem Boden fest verbunden sein und wird dann als "Bodenrahmen" bezeichnet. In diesem Fall ist der Rahmen mit dem Deckel nicht fest verbunden. Alternativ kann die Einrichtung zum Ausbilden eines Prozessraums zwei Rahmen umfassen, wobei ein erster Rahmen mit dem Deckel fest verbunden ist (und mit dem Boden nicht fest verbunden ist) und als "Deckelrahmen" bezeichnet wird, und ein zweiter Rahmen mit dem Boden fest verbunden ist (und mit dem Deckel nicht fest verbunden ist) und als "Bodenrahmen" bezeichnet wird. Boden- und Deckelrahmen sind nicht fest verbunden bzw. können zerstörungsfrei lösbar miteinander verbunden werden. Zur Formung des Prozessraums können Boden- und Deckelrahmen aufeinander gesetzt oder ineinander geschachtelt werden.

Die Vorrichtung zum Wärmebehandeln eines Mehrschichtkörpers umfasst weiterhin eine erste bzw. deckelseitige Energiequelle mit mindestens einem Heizstrahler, die unmittelbar benachbart zum Deckel angeordnet ist, sowie eine zweite bzw. bodenseitige Energiequelle mit mindestens einem Heizstrahler, die unmittelbar benachbart zum Boden angeordnet ist. Die Einrichtung zum Ausbilden eines (reduzierten) Prozessraums befindet sich zwischen der deckelseitigen Energiequelle und der bodenseitigen Energiequelle. Die deckelseitige Energiequelle und die bodenseitige Energiequelle umfassen jeweils mindestens einen Heizstrahler zum Erzeugen einer Heizstrahlung, die geeignet ist, den im Prozessraum befindlichen Mehrschichtkörper aufzuheizen. Typischer Weise hat die Heizstrahlung eine Wellenlänge im Bereich des sichtbaren Lichts (380 nm bis 780 nm) sowie im darüber liegenden infraroten Wellenlängenbereich. Der mindestens eine Heizstrahler kann linien- oder flächenförmig sein. Beispielsweise sind die deckelseitige Energiequelle und die bodenseitige Energiequelle jeweils in Form eines Heizstrahlerfelds mit einer ein- oder zweidimensionalen Anordnung von Heizstrahlern ausgebildet.

In der erfindungsgemäßen Vorrichtung zum Wärmebehandeln eines Mehrschichtkörpers bildet die deckelseitige Energiequelle, der Deckel als Zwischenelement und der Mehrschichtkörper eine erste Anordnung zum Wärmebehandeln eines Mehrschichtkörpers gemäß vorliegender Erfindung. Zusätzlich oder alternativ bildet die bodenseitige Energiequelle, der Boden als Zwischenelement und der Mehrschichtkörper eine zweite Anordnung zum Wärmebehandeln eines Mehrschichtkörpers gemäß vorliegender Erfindung. Für den Fall, dass Deckel oder Boden nicht Teil der erfindungsgemäßen Anordnung zum Wärmebehandeln eines Mehrschichtkörpers sind, bestehen sie beispielsweise aus einer Glaskeramikplatte.

Die deckelseitige Energiequelle und der Deckel sind so angeordnet, dass der im Prozessraum befindliche Mehrschichtkörper direkt durch Heizstrahlung (bei einem für die Heizstrahlung transparenten oder teiltransparenten Deckel) oder indirekt durch den aufgeheizten Deckel (bei einem für die Heizstrahlung opaken Deckel) aufgeheizt werden kann. Die deckelseitige Energiequelle befindet sich somit nicht in direkter Nachbarschaft zum Boden. In entsprechender Weise sind die bodenseitige Energiequelle und der Boden so angeordnet, dass der im Prozessraum befindliche Mehrschichtkörper direkt durch Heizstrahlung (bei einem für die Heizstrahlung transparenten oder teiltransparenten Boden) oder indirekt durch den aufgeheizten Boden (bei einem für die Heizstrahlung opaken Boden) aufgeheizt werden kann. Die bodenseitige Energiequelle befindet sich somit nicht in direkter Nachbarschaft zum Boden.

Wie oben beschrieben, kann in der mindestens einen Anordnung das Zwischenelement insbesondere ein in Form einer biegsamen Folie ausgebildetes Flächenelement aufweisen. Eine Stützeinrichtung ist hierbei nicht erforderlich. Alternativ kann das Flächenelement eine Folie oder starre Platte als Flächenelement aufweisen, wobei ergänzend eine mechanische Stützeinrichtung zum Abstützen des Flächenelements in Richtung Energiequelle vorgesehen ist.

Gemäß einer ersten Variante der Vorrichtung zum Wärmebehandeln eines Mehrschichtkörpers umfasst die Einrichtung zum Ausbilden eines Prozessraums einen einzigen Rahmen, der in diesem Fall ein mit dem Deckel fest verbundener Deckelrahmen ist. Der Deckel umfasst ein Flächenelement, welches zwischen der deckelseitigen Energiequelle und dem im Prozessraum befindlichen Mehrschichtkörper angeordnet ist, im weiteren als "Deckelflächenelement" bezeichnet, und eine Stützeinrichtung für das Deckelflächenelement, im Weiteren als "Deckelstützeinrichtung" bezeichnet.

Gemäß einer zweiten Variante der Vorrichtung zum Wärmebehandeln eines Mehrschichtkörpers umfasst die Einrichtung zum Ausbilden eines Prozessraums einen einzigen Rahmen, der in diesem Fall ein mit dem Boden fest verbundener Bodenrahmen ist. Der Boden umfasst ein Flächenelement, welches zwischen der bodenseitigen Energiequelle und dem im Prozessraum befindlichen Mehrschichtkörper angeordnet ist, im weiteren als "Bodenflächenelement" bezeichnet, und eine Stützeinrichtung für das Bodenflächenelement, im Weiteren als "Bodenstützeinrichtung" bezeichnet.

Gemäß einer dritten Variante der Vorrichtung zum Wärmebehandeln eines Mehrschichtkörpers umfasst die Einrichtung zum Ausbilden eines Prozessraums einen ersten Rahmen und einen zweiten Rahmen, wobei der erste Rahmen ein mit dem Deckel fest verbundener Deckelrahmen und der zweite Rahmen ein mit dem Boden fest verbundener Bodenrahmen ist. Entsprechend zur ersten Variante umfasst der Deckel ein Deckelflächenelement und eine Deckelstützeinrichtung. Entsprechend zur zweiten Variante umfasst der Boden ein Bodenflächenelement und eine Bodenstützeinrichtung. Der Deckelrahmen und der Bodenrahmen sind nicht fest miteinander verbunden und können zerstörungsfrei lösbar miteinander verbunden werden. Insbesondere können der Deckelrahmen und der Bodenrahmen aufeinander gesetzt oder ineinander verschachtelt werden.

Das Deckelflächenelement ist opak, teiltransparent oder transparent für die Heizstrahlung der deckelseitigen Energiequelle. Das Bodenflächenelement ist opak, teiltransparent oder transparent für die Heizstrahlung der bodenseitigen Energiequelle.

Das Deckelflächenelement und das Bodenflächenelement sind jeweils flächige-ebene Körper, die in Aufsicht auf die Ebene beispielsweise rechteckförmig ausgebildet sind. Das Deckelflächenelement bildet den Deckel flächig aus und dient zur Abdichtung des Prozessraums. Es weist eine der deckelseitigen Energiequelle zugewandte äußere Deckelfläche und eine dem Prozessraum zugewandte innere Deckelfläche auf. Das Bodenflächenelement bildet den Boden flächig aus und dient gleichermaßen zur Abdichtung des Prozessraums. Es weist eine der bodenseitigen Energiequelle zugewandte äußere Bodenfläche und eine dem Prozessraum zugewandte innere Bodenfläche auf. Vorteilhaft liegt der Mehrschichtkörper der inneren Bodenfläche auf. Vorzugsweise ist das Bodenflächenelement bzw. die innenliegende Bodenfläche mit Erhebungen strukturiert, so dass die Kontaktfläche zum Mehrschichtkörper möglichst gering ist. Damit wird der Einfluss der Wärmeleitung unterdrückt. Die Wärmeleitung kann zu räumlich sehr inhomogenem Aufheizen führen, wenn sich der Mehrschichtkörper beim Aufheizen wölbt oder schon durch Vorprozesse nicht ganz plan ist. Die Strukturierung kann durch Aufrauen oder Beschichten erfolgen mit Strukturen im Bereich von einem bis mehreren Hundert Mikrometern.

Die Deckelstützeinrichtung ist so ausgebildet, dass sie das Deckelflächenelement in Richtung zur deckelseitigen Energiequelle mechanisch abstützt. Die Deckelstützeinrichtung ist zu diesem Zweck zwischen dem Deckelflächenelement und der deckelseitigen Energiequelle angeordnet. Vorzugsweise ist die Deckelstützeinrichtung an der äußeren Deckelfläche angeordnet, vorteilhaft in Berührungskontakt mit der äußeren Deckelfäche. Vorteilhaft befindet sich die Deckelstützeinrichtung nicht innerhalb des Prozessraums. Die Deckelstützeinrichtung stützt das Deckelflächenelement nicht vollflächig ab. Vielmehr stützt die Deckelstützeinrichtung das Deckelflächenelement nur bereichsweise, d.h. nur in einem oder mehreren Bereichen des Deckelflächenelements, ab. Es wird also nicht die volle Fläche des Deckelflächenelements abgestützt. Vorzugsweise bedeckt die Deckelstützeinrichtung weniger als 10%, stärker bevorzugt weniger als 5% und am besten weniger als 2%, der äußeren Deckelfläche (in Sicht senkrecht durch das Deckelflächenelement), so dass nur eine geringfügige Abschattung der auf das Deckelflächenelement auftreffenden Heizstrahlung durch die Deckelstützeinrichtung erfolgt. Analog ist die Bodenstützeinrichtung so ausgebildet, dass sie das Bodenflächenelement in Richtung zur bodenseitigen Energiequelle mechanisch abstützt. Die Bodenstützeinrichtung ist zu diesem Zweck zwischen dem Bodenflächenelement und der bodenseitigen Energiequelle angeordnet. Vorzugsweise ist die Bodenstützeinrichtung an der äußeren Bodenfäche angeordnet, vorteilhaft in Berührungskontakt mit der äußeren Bodenfäche. Vorteilhaft befindet sich die Bodenstützeinrichtung nicht innerhalb des Prozessraums. Auch die Bodenstützeinrichtung stützt das Bodenflächenelement nicht vollflächig ab, sondern nur bereichsweise, d.h. nur in einem oder mehreren Bereichen des Bodenflächenelements. Vorzugsweise bedeckt die Bodenstützeinrichtung weniger als 10%, stärker bevorzugt weniger als 5% und am besten weniger als 2%, der äußeren Bodenfläche (in Sicht senkrecht durch das Bodenflächenelement), so dass nur eine geringfügige Beeinträchtigung der auf das Bodenflächenelement auftreffenden Heizstrahlung durch die Bodenstützeinrichtung auftritt.

Die Gestaltung von Deckel und/oder Boden der Einrichtung zum Ausbilden eines (reduzierten) Prozessraums als Zwischenelement der erfindungsgemäßen Anordnung zum Wärmebehandeln eines Mehrschichtkörpers ermöglicht in vorteilhafter Weise durch eine Verringerung der Masse des Zwischenelements eine Verringerung der Gesamtmasse der Einrichtung zur Ausbildung eines Prozessraums, ohne hierdurch deren mechanische Stabilität zu beeinträchtigen. Da somit bei der Wärmebehandlung des im Prozessraum befindlichen Mehrschichtkörpers weniger Masse der Einrichtung zur Ausbildung eines Prozessraums miterhitzt (bzw. abgekühlt) wird, können in erheblichem Umfang Energiekosten eingespart werden. Da das Zwischenelement durch die zugehörige Stützeinrichtung nicht vollflächig, sondern nur bereichsweise unterstützt ist, ist die freie Sicht der Heizstrahlung auf das Flächenelement nur wenig beeinträchtigt, so dass der Mehrschichtkörper flächig-homogen aufgeheizt werden kann und nur geringe thermische Inhomogenitäten auftreten. Das Flächenelement (Deckel oder Boden) kann gezielt im Hinblick auf die gasdichte Ausbildung des Prozessraums bei geringer Masse und Korrosionbeständigkeit optimiert werden, wobei durch die Stützeinrichtung eine ausreichende mechanische Stabilität gewährleistet ist.

Das Flächenelement kann bei der Ausbildung als dünne starre Platte insbesondere eine sich senkrecht zur Flächenebene bemessende Dicke aufweisen, bei der ohne mechanische Stützeinrichtung schon aufgrund des Eigengewichts (Deckel) oder aufgrund des Eigengewichts plus Gewicht des Mehrschichtkörpers und gegebenenfalls Gewicht von Deckel und Rahmen (Boden) ein Bruch wahrscheinlich ist oder zumindest eine im Hinblick auf die hohen Güteanforderungen nicht mehr akzeptable Durchbiegung senkrecht zur Flächenebene auftritt (elastische Durchbiegung von mehr als 2 mm pro Quadratmeter). Mit Stützeinrichtung beträgt die Durchbiegung des Flächenelements vorzugsweise weniger als 1 mm.

Die Erfindung erstreckt sich weiterhin auf ein Verfahren zum Wärmebehandeln eines Mehrschichtkörpers, welches umfasst:

- Bereitstellen des Mehrschichtkörpers in einer wie oben beschriebenen Vorrichtung zum Wärmebehandeln eines Mehrschichtkörpers,
- Bestrahlen des Mehrschichtkörpers mit auf Deckel und Boden gerichteten Heizstrahlungen.

Für die Ausgestaltung der Vorrichtung zum Wärmebehandeln eines Mehrschichtkörpers zur Durchführung des erfindungsgemäßen Verfahrens wird auf obige Ausführungen Bezug genommen.

Des Weiteren erstreckt sich die Erfindung auf die Verwendung des erfindungsgemäßen Verfahrens zum Wärmebehandeln eines Mehrschichtkörpers zur Herstellung eines Absorbers bei der Fertigung von Dünnschichtsolarzellen.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Kurze Beschreibung der Zeichnungen

Die Erfindung wird nun näher erläutert, wobei Bezug auf die beigefügten Figuren genommen wird. Es zeigen:

Fig. 1     eine Querschnittansicht einer Vorrichtung zum Wärmebehandeln eines Mehrschichtkörpers zur Veranschaulichung der thermischen Verhältnisse beim Heizen des Mehrschichtkörpers;

Fig. 2     eine Querschnittansicht der Vorrichtung zum Wärmebehandeln eines Mehrschichtkörpers von Figur 1;

Fig. 3     eine schematische Darstellung einer Anordnung bestehend aus Energiequelle, Zwischenelement und Mehrschichtkörper;

Fig. 4     ein Ausführungsbeispiel für ein Zwischenelement in einer Querschnittansicht;

Fig. 5     das Zwischenelement von Figur 4 in Aufsicht;

Fig. 6     ein weiteres Ausführungsbeispiel für ein Zwischenelement in einer Querschnittansicht;

Fig. 7     das Zwischenelement von Figur 6 in Aufsicht;

Fig. 8     ein weiteres Ausführungsbeispiel für ein Zwischenelement in einer Querschnittansicht;

Fig. 9     eine weitere Querschnittansicht des Zwischenenelements von Figur 8;

Fig. 10    das Zwischenelement von Figur 8 in Aufsicht;

Fig. 11    das Zwischenelement von Figur 8 in Aufsicht in einer Variante;

Fig. 12    die Querschnittansicht von Figur 9 mit Ergänzungen;

Fig. 13    ein Flussdiagramm zur Veranschaulichung der Verfahrensschritte des erfindungsgemäßen Verfahrens zum Wärmebehandeln eines Mehrschichtkörpers.

Ausführliche Beschreibung der Zeichnungen

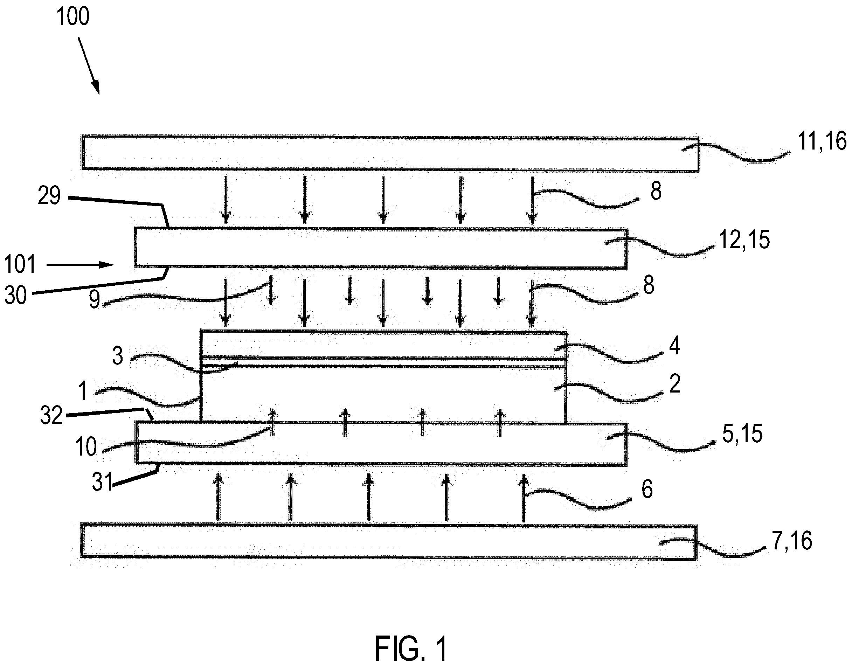

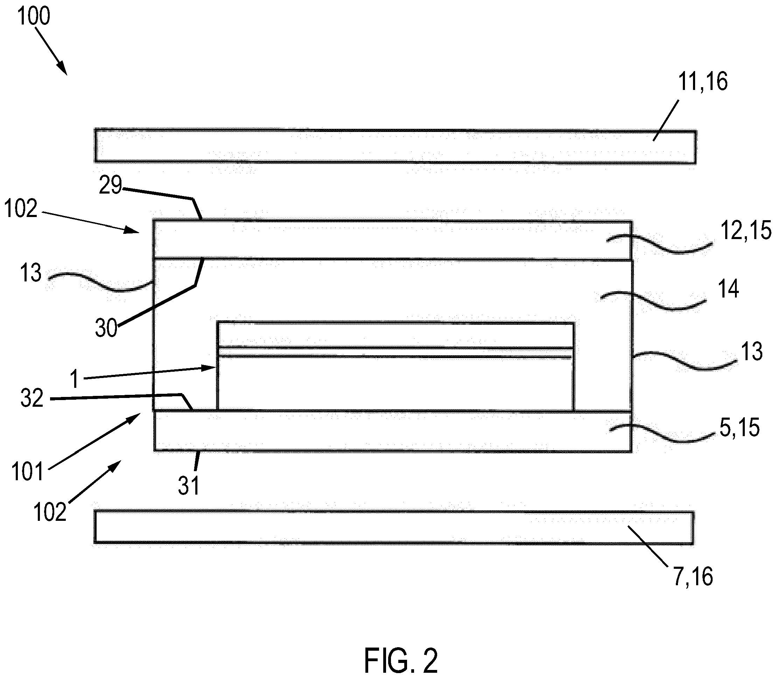

Seien zunächst die Figuren 1 und 2 betrachtet, worin eine insgesamt mit der Bezugszahl 100 bezeichnete Vorrichtung zum Wärmebehandeln eines Mehrschichtkörpers 1 gemäß vorliegender Erfindung in schematischer Weise anhand einer Querschnittansicht (Schnitt senkrecht zur Substratoberfläche) veranschaulicht ist. In Figur 1 sind die wesentlichen Heizvorgänge beim Wärmebehandeln des Mehrschichtkörpers 1 herausgestellt, Figur 2 zeigt den Aufbau bei der Wärmebehandlung des Mehrschichtkörpers 1.

Die Vorrichtung 100 zum Wärmebehandeln eines Mehrschichtkörpers 1 umfasst eine insgesamt mit der Bezugszahl 101 bezeichnete Einrichtung zum Ausbilden eines (reduzierten) Prozessraums. Die Einrichtung 101 umfasst einen Boden 5, einen Deckel 12, sowie einen Rahmen 13, der Boden 5 und Deckel 12 räumlich miteinander verbindet und gleichzeitig als Abstandhalter für Boden 5 und Deckel 12 dient. Boden 5, Deckel 12 und Rahmen 13 formen gemeinsam einen gasdichten Prozessraum 14 (siehe Figur 2), in dem der Mehrschichtkörper 1 einer Wärmebehandlung unterzogen werden kann. Der Mehrschichtkörper 1 liegt hier beispielsweise dem Boden 5 auf.

Der Mehrschichtkörper 1 umfasst ein Substrat 2, z.B. eine Glasplatte, sowie eine auf das Substrat 2 aufgebrachte Rückelektrodenschicht 3, z.B. aus Molybdän, und eine hierauf aufgebrachte Vorläuferschicht (Precursor) 4, welche zu einem Verbindungshalbleiter thermisch umgesetzt werden soll. Für die Herstellung einer Cu(In,Ga)(S,Se)$_2$-Absorberschicht besteht die Vorläuferschicht 4 aus verschiedenen Einzellagen, welche Kupfer, Indium und Gallium enthalten, die beispielsweise durch Sputtern aufgebracht sind. Weiterhin enthält die Vorläuferschicht 4 mindestens ein Chalkogen in elementarer Form, vorzugsweise Selen und/oder Schwefel, welches vorzugsweise durch thermisches Verdampfen aufgebracht wird. Die Vorläuferschicht 4 wird durch Erwärmen in einer mindestens ein Chalkogen (Selen und/oder Schwefel) enthaltenden Atmosphäre zum Cu(In,Ga)(S,Se)$_2$-Verbindungshalbleiter reagiert (thermisch umgesetzt). Beispielsweise enthält die Vorläuferschicht 4 als Chalkogen nur elementares Selen und die thermische Umsetzung der Vorläuferschicht erfolgt in einer Atmosphäre, die als Chalkogen nur Schwefel enthält. Die thermische Umsetzung der Vorläuferschicht 4 erfolgt im Prozessraum 14.

Angrenzend an und unmittelbar benachbart zum Deckel 12 befindet sich als deckelseitige Energiequelle ein Deckelstrahlerfeld 11 mit einer Vielzahl von in einer ein- oder zweidimensionalen Anordnung (Array) platzierten Heizstrahlern (z.B. Halogenlampen, Infrarotstrahler oder Flächenstrahler) zum Emittieren von Heizstrahlung zum deckelseitigen Heizen des Mehrschichtkörpers 1. In analoger Weise befindet sich angrenzend an und unmittelbar benachbart zum Boden 5 als bodenseitige Energiquelle ein Bodenstrahlerfeld 7 mit einer Vielzahl von in einer ein- oder zweidimensionalen Anordnung (Array) platzierten Heizstrahlern (z.B. Halogenlampen, Infrarotstrahler oder Flächenstrahler) zum Emittieren von Heizstrahlung zum bodenseitigen Heizen des Mehrschichtkörpers 1. Die Einrichtung 101 zum Ausbilden eines Prozessraums 14 befindet sich zwischen dem Bodenstrahlerfeld 7 und dem Deckelstrahlerfeld 11. Sowohl Boden 5 als auch Deckel 12 können in verallgemeinerter Weise jeweils als Zwischenelement 15 betrachet werden, das sich zwischen einer Energiequelle 16 (Bodenstrahlerfeld 7 bzw. Deckelstrahlerfeld 11) und dem Mehrschichtkörper 1 befindet. Der Deckel 12 weist eine dem Deckelstrahlerfeld 11 zugewandte äußere Deckelfläche 29 und gegenüberliegend eine dem Mehrschichtkörper 1 zugewandte innere Deckelfläche 30 auf. Der Boden 5 weist eine dem Bodenstrahlerfeld 7 zugewandte äußere Bodenfläche 31 und gegenüberliegend eine dem Mehrschichtkörper 1 zugewandte innere Bodenfläche 32 auf. Der Mehrschichtkörper 1 liegt der inneren Bodenfläche 32 vorzugsweise auf.

Wie in Figur 1 veranschaulicht, emittieren die Heizstrahler des Deckelstrahlerfelds 11 die obere Heizstrahlung 8, welche auf die äußere Deckelfläche 29 trifft, den (hier beispielsweise teiltransparenten) Deckel 12 teilweise passiert und auf die Oberseite des Mehrschichtkörpers 1 trifft, d.h. auf die Vorläuferschicht 4. Der Mehrschichtkörper 1 liegt im Bereich der oberen Heizstrahlung 8. Ein Teil der oberen Heizstrahlung 8 wird vom Deckel 12 absorbiert und erwärmt den Deckel 12, der seinerseits die Wärmestrahlung 9 emittiert, die gleichermaßen den Mehrschichtkörpr 1 heizt. Die Heizstrahler des Bodenstrahlerfelds 7 emittieren die untere Heizstrahlung 6, welche auf die äußere Bodenfläche 31 des (hier beispielsweise teiltransparenten) Bodens 5 trifft und den Boden 5 erwärmt. Der Boden 5 gibt die Energie durch Wärmeleitung 10 und Wärmestrahlung an den Mehrschichtkörper 1 weiter. Während der Mehrschichtkörper 1 von oben her in erster Linie durch die obere Heizstrahlung 8 erwärmt wird, wird er von unten her durch Wärmeleitung 10 und Wärmestrahlung des erwärmten Bodens 5 erwärmt.

Nach dem Ablegen des Mehrschichtkörpers 1 auf den Boden 5 wird der Prozessraum 14 mit dem Prozeßgas befüllt und verschlossen. Danach erfolgt das Temperieren mit einer Temperierrate von mehreren °C pro Sekunde, beispielsweise 5 °C/s, wobei das Deckelstrahlerfeld 11 und das Bodenstrahlerfeld 7 zum Erzeugen einer definierten Heizleistung auch getrennt geregelt werden können. Durch das Mitheizen von Deckel 12 und Boden 5 kann eine Kondensation flüchtiger Bestandteile der Atmospäre des Prozessraums 14 zumindest weitestgehend verhindert werden.

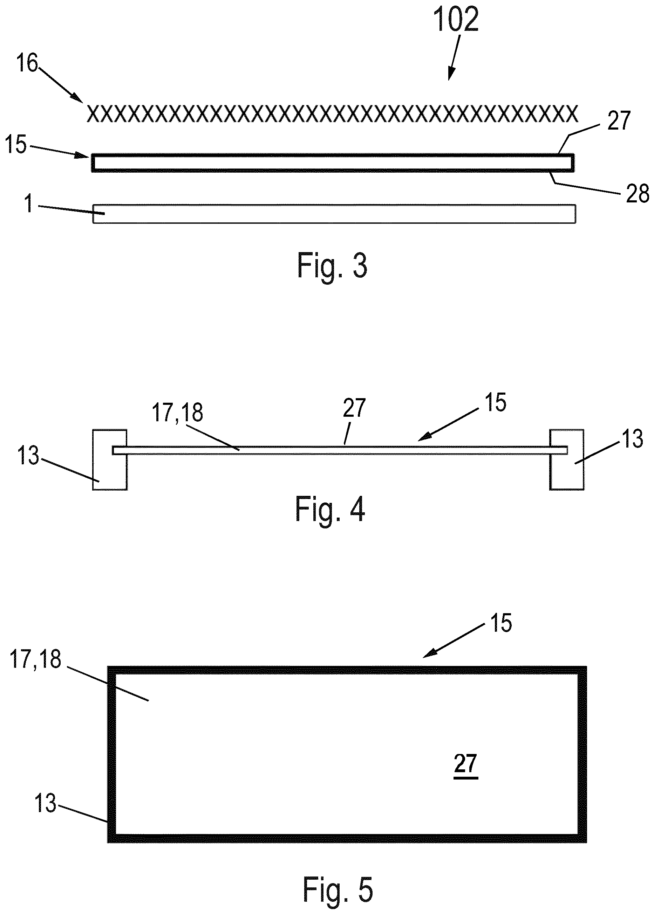

Figur 3 zeigt eine schematische Darstellung einer Anordnung bestehend aus Energiequelle 16 (wie Bodenstrahlerfeld 7 oder Deckelstrahlerfeld 11), Zwischenelement 15 (wie Boden 5 oder Deckel 12) und Mehrschichtkörper 1, wie sie auch in den Figuren 1 und 2 realisiert ist. Das Zwischenelement weist eine der Energiequelle 16 zugewandte erste Fläche 27 und eine von der Energiequelle 16 abgewandte zweite Fläche 28 auf. Die Heizstrahlung der Energiequelle 16 trifft auf die erste Fläche 27.

Die Heizenergie, die ohne Zwischenelement 15 notwendig wäre, um den Mehrschichtkörper 1 auf die gewünschte Temperatur aufzuheizen, stellt den minimalen Energieverbrauch $E_0$ dar. Die wesentliche Verlustquelle beim Aufheizen des Mehrschichtkörpers 1 ist die Energie $E_z = \Delta Q$, die zum Aufheizen des Zwischenelementes 15 notwendig ist, gegeben durch die Formel:

$$E_z = \Delta Q = c * M * \Delta T$$

M ist die Masse, c die Wärmekapazität, $\Delta T$ die gewünschte Erwärmung des Zwischenelementes 15.

Je größer die Masse M und die Wärmekapazität c des Zwischenelementes 15 sind, desto höher ist der Energieverlust $E_z$. Der Verringerung der Masse M steht die geringere mechanische Belastbarkeit entgegen. Dünnere Glaskeramik würde in der erforderlichen Größe (z.B. 1 - 2 $m^2$) schon aufgrund des Eigengewichtes oder aufgrund des Gewichtes von Substrat + Boden + Deckel + Rahmen und der zusätzlichen mechanischen Belastungen bei Transport und durch Druckdifferenzen (Boden) zu stark durchbiegen oder brechen. Insofern scheidet eine bloße Verringerung der Dicke eines glaskeramischen Zwischenelements 15 aus.

Eine stationäre Prozesshaube unterliegt keinen so großen Temperaturschwankungen wie eine transportable Prozessbox, wenn sie sich ständig im Strahlungsfeld der Heizstrahler befindet. Die stationäre Prozesshaube hat dann während des Heizprozesses kaum Möglichkeit abzukühlen und wird unabhängig von deren Masse im stationären Betrieb eine Temperatur annehmen, die sich aus der Bilanz von Energieeintrag durch Strahlung der Heizstrahler und Energieverlust durch Strahlung, Wärmeleitung und Konvektion ergibt. Wird eine stationäre Prozesshaube bei der heizerunterstützten Abkühlung eingesetzt, kühlt auch diese merklich ab und wird beim nächsten Mehrschichtkörper wieder mit aufgeheizt. Im Unterschied hierzu weist die transportable Prozessbox annähernd Raumtemperatur auf und muss bei der Wärmebehandlung des Mehrschichtkörpers von neuem erwärmt und wieder auf nahe Raumtemperatur abgekühlt werden.

Denkbar wäre, ein Zwischenelement 15 mit einer möglichst hohen Transparenz zu verwenden, so dass die Absorption der Heizleistung sehr gering ist. Obige Formel kann hierzu umgeschrieben werden zu:

$$r = \Delta T / \Delta t = P_{abs} / (c * M)$$

Hier ist r die Heizrate und $P_{abs}$ die absorbierte Heizstrahlung. Die Gleichung lässt sich sowohl auf das Zwischenelement 15 als auch den Mehrschichtkörper 1 anwenden. Demnach erhöht sich die Heizrate r mit kleiner werdender Masse M und Wärmekapazität c. Wenn durch sehr geringe Absorption die absorbierte Strahlungsenergie $P_{abs}$ jedoch sehr gering ist, kann man den Mehrschichtkörper 1 durch das transparente Zwischenelement 15 aufheizen, ohne dass dieses sich in gleichem Maße mit aufheizt. In einem kontinuierlichen Betrieb hängt der Energieverlust durch Aufheizen des Zwischenelements 15 von der Absorption des Zwischenelements 15, der mittleren Heizleistung und der Taktzeit ab, da jedes neue Substrat (Mehrschichtkörper 1) wiederum über Wärmestrahlung und Wärmeleitung zur Kühlung des Zwischenelements 15 beiträgt. Im Fall der mobilen Prozessbox kommt dann noch die aktive Kühlung am Ende des Prozesszyklus hinzu.

Zwar gibt es Glaskeramiken mit höherer Transparenz, jedoch hat sich gezeigt, dass die Absorption immer noch so hoch ist, dass sich die Glaskeramik bei einer mobilen Prozessbox über den gesamten Prozesszyklus doch auf nahezu Substrattemperatur aufheizt. Quarz ist in den erforderlichen Größen sehr teuer, wenn überhaupt verfügbar. Hinzu kommt, dass wenn die Temperatur des Zwischenelements 15 deutlich kälter ist als die des Substrats, Selen oder andere gasförmige Verbindungen mit geringerem Schmelzpunkt dort zumindest temporär kondensieren können. Dies führt zu einem temporären Chalkogenverlust in einer kritischen Prozessphase. Bei stärker werdender Kondensation wird die Absorption der Heizstrahlung in den Kondensaten zunehmen. Es wird sich ein stationärer Zustand einstellen.

Die Erfindung geht hier einen anderen Weg, indem die Masse des Zwischenelements 15 über eine verbesserte Konstruktion und geeignete dünnere Materialien erheblich reduziert wird. Durch die weitaus geringere Masse des Zwischenelements 15 können auch opake Materialen hierfür verwendet werden. Die gewünschten schnellen Heizraten von typischer Weise 1 bis 5 °C/s können nur bei Verwendung sehr dünner Zwischenelemente 15 erreicht werden. Insbesondere können die Aufgaben der gasdichten und korrosionsfesten Abdichtung des Prozessraums und die mechanische Stabilisierung durch das Zwischenelement 15 mittels einer Kombination aus flächigem Flächenelement und zugehöriger Stützeinrichtung getrennt und separat optimiert werden.

Dies wird nachfolgend näher erläutert. Die Figuren 4 und 5 veranschaulichen dies anhand eines neuartigen Zwischenelements 15, das als Deckel 12 und/oder Boden 5 der Vorrichtung 100 zum Wärmebehandelns eines Mehrschichtkörpers 1 der Figuren 1 und 2 eingesetzt werden kann.

Demnach ist das Zwischenelement 15 ein Flächenelement 17, das hier beispielsweise in Form einer biegsamen Folie 18 ausgebildet ist. Figur 4 zeigt eine Querschnittansicht (senkrecht zur Ebene des Flächenelements 17), Figur 5 zeigt eine Aufsicht. Die Folie 18 ist innerhalb des Rahmens 13 aufgespannt, wobei der Innenbereich des Rahmens 13 vollständig von der Folie 18 überspannt wird. Die Folie 18 ist mit dem Rahmen 13 fest verbunden. Die Folie 18 weist eine Dicke von weniger als 0,5 mm, vorzugsweise weniger als 0,3 mm auf. Die Verspannung der Folie 18 muss so stark sein, dass sie den mechanischen Belastungen standhalten kann. Dies gilt insbesondere für den Fall, dass das Zwischenelement 15 als Boden 5 eingesetzt wird, auf den das Gewicht des Mehrschichtkörpers 1 und gegebenenfalls das Gewicht von Rahmen 13 und Deckel 12 lastet. Durch Druckdifferenzen (bei Pump-/Spülzyklen) und konvektive Kühlung können Belastungen von bis zu 40kg/m² auftreten. Als Materialien für die Folie 18 kommt beispielsweise Graphit mit oder ohne Korrosionsinhibitor oder ein Verbundwerkstoff, beispielsweise kohlenstofffaserverstärkter Kohlenstoff, zum Einsatz. Alternativ kann eine ein- oder beidseitig mit einer Korrosionsschutzschicht beschichtete Metallfolie verwendet werden. Eine weitere Alternative ist eine Verbundfolie, bei der eine Metallfolie mittels eines keramischen oder Graphitklebers ein- oder beidseitig mit einer Graphitfolie verbunden ist. Metallfolien sind mechanisch äußerst stabil hinsichtlich Biegezugfestigkeit und Reißfestigkeit, so dass sie sehr dünn sein können. Die hohe Wärmeleitfähigkeit sorgt für eine homogene Temperaturverteilung. Die Korrosionsstabilität übernimmt die Graphitfolie. Die Folie hat vorzugsweise eine geringe Reflektivität und eine hohe Emissivität, damit die vom Strahlerfeld emittieret Strahlung weitestgehend absorbiert wird.

Wenn die Folie den Boden 5 ausbildet, ist die Folie vorzugsweise mit Erhebungen strukturiert, so dass die Kontaktfläche zum Mehrschichtkörper 1 möglichst gering ist. Damit wird der Einfluss der Wärmeleitung unterdrückt.

Wenn sowohl der Deckel 12 als auch der Boden 5 der Vorrichtung 100 zum Wärmebehandeln eines Mehrschichtkörpers 1 der Figuren 1 und 2 in Form des in den Figuren 4 und 5 gezeigten Zwischenelements 15 ausgebildet sind, gibt es zwei Rahmen 13, die auf- oder ineinander gelegt werden können und dabei nicht fest miteinander verbunden sind bzw. zerstörungsfrei lösbar miteinander verbunden werden.

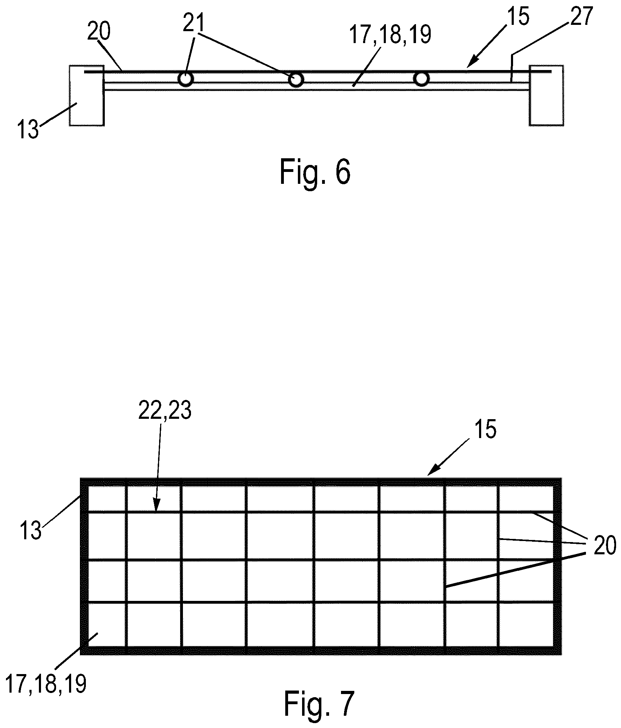

In Figur 6 ist anhand einer Querschnittansicht ein weiteres Ausführungsbeispiel des Zwischenelements 15 veranschaulicht. Bei dem Zwischenelement 15 handelt es sich um eine Weiterbildung des Zwischenelements 15 der Figuren 4 und 5. Figur 7 zeigt eine Aufsicht auf das Zwischenelement 15. Um unnötige Wiederholungen zu vermeiden, werden nur die Unterschiede zum Ausführungsbeispiel der Figuren 4 und 5 beschrieben und ansonsten wird auf obige Ausführungen Bezug genommen.

Demnach umfasst das Zwischenelement 15 ein Flächenelement 17, das als biegsame Folie 18 oder als starre Platte 19 ausgebildet ist. Wie die biegsame Folie 18 erstreckt sich die starre Platte 19 über den kompletten Innenbereich des Rahmens 13. Das Zwischenelement 15 umfasst weiterhin eine Stützeinrichtung 22, die hier beispielsweise als Drahtgitter 23 ausgebildet ist. Das Drahtgitter 23 setzt sich aus einer Mehrzahl geradliniger Drähte 20 zusammen, die sich kreuzen und miteinander verbunden sind. Die sich kreuzenden Drähte 20 formen eine Vielzahl polygoner Maschen. Das Drahtgitter 20 erstreckt sich über die komplette Fläche (d.h. erste Fläche 27) des Flächenelements 17 innerhalb des Rahmens 13. Wie in Figur 6 erkennbar, ist das Drahtgitter 23 an Verbindungsstellen 21 mit dem Flächenelement 17 fest verbunden. Für eine feste Verbindung des Zwischenelements 15 mit dem Rahmen 13 ist beispielsweise das Flächenelement 17 fest mit dem Rahmen 13 verbunden (z.B. eingespannt), wobei die Stützeinrichtung 22 nicht mit dem Rahmen 13 direkt fest verbunden ist. Alternativ wäre es möglich, dass die Stützeinrichtung 22 fest mit dem Rahmen 13 verbunden ist, wohingegen das Flächenelement 17 nicht mit dem Rahmen 13 fest verbunden ist. Das Flächenelement 17 wird dann über die Stützeinrichtung 22 aufgespannt bzw. befestigt. Wiederum alternativ wäre es möglich, dass sowohl das Flächenelement 17 als auch die Stützeinrichtung 22 jeweils direkt mit dem Rahmen 13 fest verbunden sind.

Die Stützeinrichtung 22 ist auf der der Energiequelle 16 zugewandten Seite des Flächenelements 17 angeordnet, hier beispielsweise in Berührungskontakt mit der ersten Fläche 27 des Flächenelements 17. Die Stützeinrichtung 22 stützt das Flächenelement 17 flächig in Richtung der Energiequelle 16 ab und gewährleistet eine ausreichende mechanische Stabilität des Flächenelements 17.

Die Verbindungsstellen 21 bestehen beispielsweise aus einem Klebstoff mit geringer Wärmeleitfähigkeit, z.B. aus einem Keramikkleber. Da die Verbindungsstellen 21 das Flächenelement 17 an den Drähten 20 befestigt, muss das Flächenelement 17 nicht notwendigerweise im Rahmen 13 eingespannt sein, da die auftretende mechanische Belastung von den Drähten 20 getragen wird. Die mechanische Belastung wird durch die Drähte 20 aufgenommen, wobei im Vergleich zum Ausführungsbeispiel der Figuren 4 und 5, bei denen das Flächenelement 17 nicht durch eine mechanische Stützeinrichtung 22 abgestützt ist, höhere mechanische Belastungen hinsichtlich der auftretenden Gewichts- und Biegekräfte möglich sind. Die Folie 18 oder dünne Platte 19 muss nur so am Rahmen 13 befestigt werden, dass der Prozessraum ausreichend gasdicht ist.

Das Flächenelement 17 kann als eine starre Platte 19 mit geringer Dicke ausgebildet sein. Als Material kann beispielsweise ein Verbundwerkstoff, wie kohlenstofffaserverstärkter Kohlenstoff, Glaskeramik oder ein Glas mit hohem Erweichungspunkt wie ein Borosilikatglas, Aluminosilikatglas oder Quarzglas, verwendet werden. Die Platte 19 ist dünn und weist vorzugsweise eine Dicke von weniger als 4 mm, stärker bevorzugt weniger als 1 mm, noch stärker bevorzugt weniger als 0,3 mm auf.

Die Drähte 20 bestehen aus einem Metall, beispielsweise einer Molybdän- oder Wolfram-Legierung. Die Drähte 20 können zusätzlich mit einer Korrosionsschutzschicht beschichtet sein, welche beispielsweise

aus $Al_2O_3$, MoN, $Si_3N_4$ oder dergleichen besteht.

Wenn die Wärmeleitfähigkeit der Folie 18 oder dünnen Platte 19 gut ist, wird die Verschattung durch die Drähte 20 kaum einen Einfluss auf die Abstrahlung zum Mehrschichtkörper 1 haben. In dieser Ausführungsform kann die Masse des Zwischenelementes 15 gering sein. Durch die Verbundtechnik sind die Anforderungen und die Funktionen auf die zwei Komponenten aufgeteilt: die Hauptlast der Korrosionsfestigkeit und die Abdichtung übernimmt die Folie 18 bzw. die dünne Platte 19, das Drahtgitter 23 übernimmt die mechanischen Anforderung hinsichtlich Zug- und Biegezugfestigkeit.

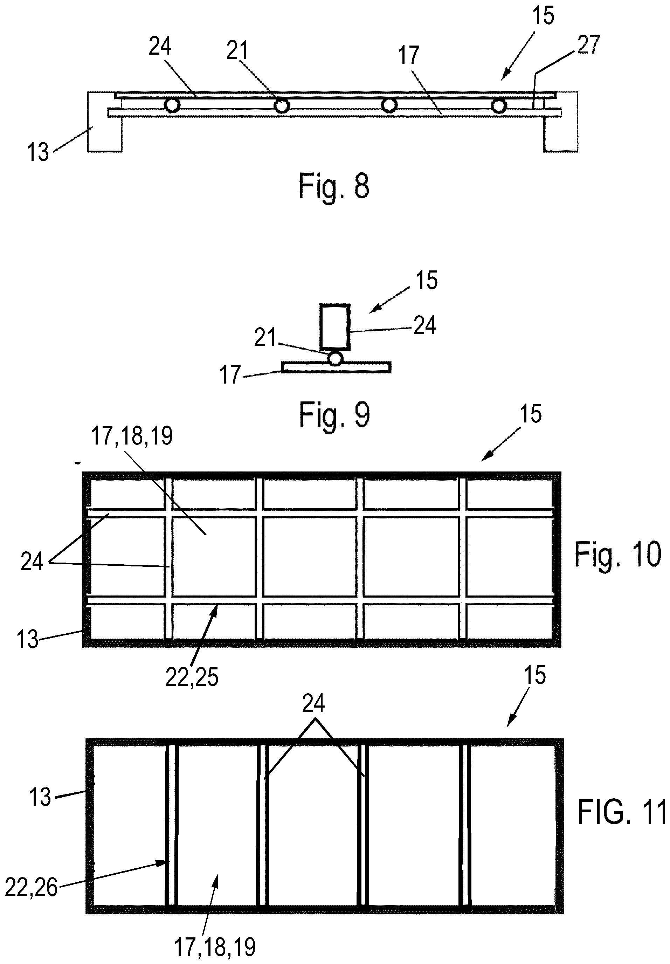

Es seien nun die Figuren 8 bis 11 betrachtet worin ein weiteres Ausführungsbeispiel des Zwischenelements 15 veranschaulicht ist. Figur 8 zeigt eine Querschnittansicht (senkrecht zum Flächenelement 17), Figur 9 gleichfalls eine Querschnittansicht (senkrecht zum Flächenelement 17, aber senkrecht zur Figur 8), Figur 10 eine Aufsicht, Figur 11 eine weitere Aufsicht. Um unnötige Wiederholungen zu vermeiden, werden nur die Unterschiede zum Ausführungsbeispiel der Figuren 6 und 7 beschrieben und ansonsten wird auf obige Ausführungen Bezug genommen.

Demnach umfasst das Zwischenelement 15 eine Stützeinrichtung 22, die hier nicht durch Drähte 20, sondern durch Stäbe 24 gebildet wird. Wie in der Aufsicht von Figur 10 gezeigt, können die Stäbe 24 in Form eines Stabgitters 25 mit sich kreuzenden Stäben 24 angeordnet sein, analog zum Drahtgitter 23. Das Stabgitter 25 weist eine Vielzahl polygoner Maschen auf. In einer alternativen Ausgestaltung, die in Figur 11 gezeigt ist, sind die Stäbe 24 in Form einer Linienanordnung 26 mit parallel nebeneinander angeordneten Stäben 24 angeordnet. Das Stabgitter 25 bzw. die Linienanordnung 26 erstreckt sich über die komplette Fläche (d.h. erste Fläche 27) des Flächenelements 17 innerhalb des Rahmens 13. Wie insbesodere in Figur 9 erkennbar, sind die Stäbe 24 jeweils an Verbindungsstellen 21 mit dem Flächenelement 17 fest verbunden.

Die Stäbe 24 bestehen beispielsweise aus Graphit, Metall, Keramik, oder Glaskeramik. Vorzugsweise haben die Stäbe 24 einen rechteckigen Querschnitt. Durch einen rechteckigen Querschnitt mit der kurzen Seite parallel zum Flächenelement 17 kann eine hohe Steifigkeit bei reduzierter Verschattung erreicht werden. Der Querschnitt der Stäbe 24 kann aber auch, je nach Material und Konstruktion vorteilhaft kreisförmig (Rundstab), ringförmig (Rohr), T-förmig (T-Träger) oder doppel-T förmig (Doppel-T-Träger) sein. Vorteilhaft sind die Stäbe 24 aus einem teiltransparenten, stärker bevorzugt einem transparenten Material gefertigt. Vorzugsweise beträgt die Absorption der Heizstrahlung in den Stäben 24 weniger als 20%, bevorzugt weniger als 10%, und noch stärker bevorzugt weniger als 5%. Durch die Transparenz ist die Abschattung der Heizstrahlung auf das Flächenelement 17 sehr gering. Über die Heizstrahlung und Wärmeleitung werden sich die Stäbe 24 über die Dauer des Prozesses aufheizen. Je nach Konstruktion kann es jedoch einen dauerhaften Temperaturgradienten zwischen Flächenelement 17 und Stäben 24 kommen.

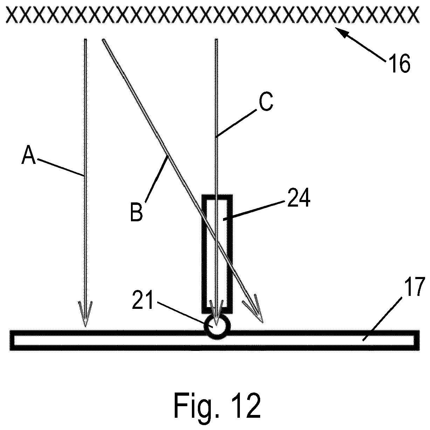

In Figur 12 ist in Ergänzung zu Figur 9 die Energiequelle 16 dargestellt. Erkennbar tritt durch einen transparenten Stab 24 nur eine sehr geringfügige Störung der Heizstrahlung 6, 8 auf. Der senkrecht auf die Oberfläche (d.h. erste Fläche 27) des Flächenelements 17 auftreffende Heizstrahl A passiert den Stab 24 seitlich. Der gleichermaßen senkrecht auf die Oberfläche des Flächenelements 17 auftreffende Heizstrahl C kann den transparenten Stab 24 großteils passieren. Der den Stab 24 quer passierende Heizstrahl B kann ebenfalls auf die Oberfläche des Flächenelements 17 treffen.

Bei der Verwendung von Stäben 24 ist es vorteilhaft, zwischen Stäbe 24 und Flächenelement 17 einen thermischen Isolator einzubauen. Das kann vorteilhaft ein keramischer Kleber sein. Die Befestigung kann auch punktförmig erfolgen zur Reduzierung von Kältebrücken. Wenn die Wärmeleitfähigkeit des Flächenelements 17 hoch ist, die des Verbindungsmaterials jedoch niedrig, kann der Effekt des verzögerten Aufheizens minimiert werden. Durch die senkrecht zur Ebene des Flächenelements 17 gerichteten Stäbe 24 kann das Flächenelement 17 deutlich versteift werden. Die mechanischen Anforderungen an das Flächenelement 17 können dadurch reduziert werden, so dass die freitragende Fläche zwischen den Stäben 24 deutlich reduziert wird. Der Abstand und der Querschnitt der Stäbe 24 sollte so optimiert werden, dass die Biegezugfestigkeit des Flächenelements 17 ausreicht, um die Druckbelastungen auf die freitragende Fläche zwischen zwei Stäben 24 auszuhalten. Die Gesamtmasse aus Anzahl, Abstand und Querschnitt der Stäbe 24 sollte dabei nur so groß wie nötig gewählt werden. Es versteht sich, dass die senkrecht zum Flächenelement 17 stehenden Stäbe 24 eine weitaus bessere Optimierung aus Masse und Steifigkeit darstellen als nur eine flache Platte. Das Flächenelement 17 mit einem Stabgitter 25 oder einer Linienanordnung 26 aus Stäben 24 bildet einen Verbundkörper mit deutlich höherer Steifigkeit und geringer Masse.

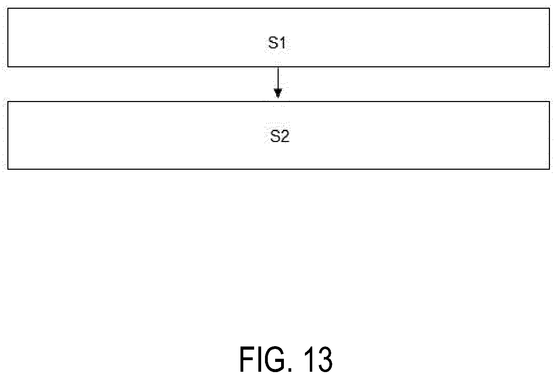

In Figur 13 ist das Verfahren zum Wärmebehandeln eines Mehrschichtkörpers 1 veranschaulicht. Es umfasst einen ersten Schritt S1, bei dem der Mehrschichtkörper 1 in einer erfindungsgemäßen Vorrichtung 100 zum Wärmebehandeln eines Mehrschichtkörpers 1 bereitgestellt wird, sowie einen zweiten Schritt S2, bei dem der Mehrschichtkörper 1 mit Heizstrahlung boden- und deckelseitig bestrahlt wird. Die jeweilige Heizstrahlung trifft auf Deckel und Boden der Einrichtung zum Ausbilden eines (reduzierten) Prozessraums.

Die Erfindung stellt eine verbesserte Anordnung, Vorrichtung und Verfahren zum Wärmebehandeln eines Mehrschichtkörpers zur Verfügung, bei der die Masse mindestens eines Zwischenelements erheblich reduziert werden kann. Das Zwischenelement weist entweder ein in Form einer biegsamen Folie ausgebildetes Flächenelement auf, oder ein Flächenelement, das in Form einer biegsamen Folie oder einen dünnen starren Platte ausgebildet ist, und durch eine Stützeinrichtung mechanisch abgestützt ist. Durch die verringerte Masse können Kosten bei der Wärmebehandlung des Mehrschichtkörpers eingespart werden, ohne die mechanische Stabilität und Korrosionsfestigkeit des Zwischenelements zu beeinträchtigen.

Bezugszeichenliste

1      Mehrschichtkörper
2      Substrat
3      Rückelektrodenschicht
4      Vorläuferschicht
5      Boden
6      untere Heizstrahlung
7      Bodenstrahlerfeld
8      obere Heizstrahlung
9      Wärmestrahlung
10      Wärmeleitung
11      Deckelstrahlerfeld
12      Deckel
13      Rahmen
14      Prozessraum
15      Zwischenelement
16      Energiequelle
17      Flächenelement
18      Folie
19      Platte
20      Draht
21      Verbindungsstelle
22      Stützeinrichtung
23      Drahtgitter
24      Stab
25      Stabgitter
26      Linienanordnung
27      erste Fläche
28      zweite Fläche
29      äußere Deckelfläche
30      innere Deckelfläche
31      äußere Bodenfläche
32      innere Bodenfläche
100      Vorrichtung zum Wärmebehandeln eines Mehrschicht körpers 1
101      Einrichtung zum Ausbilden eines Prozessraums 14
102      Anordnung zum Wärmebehandeln eines Mehrschichtkör pers 1

**Patentansprüche**

1. Anordnung (102) zum Wärmebehandeln eines Mehrschichtkörpers (1), umfassend:

     - eine Energiequelle (16, 7, 11) mit mindestens einem Heizstrahler zur Erzeugung einer Heizstrahlung (6, 8),
     - einen Mehrschichtkörper (1),
     - ein zwischen der Energiequelle (16, 7, 11) und dem Mehrschichtkörper (1) angeordnetes Zwischenelement (15, 5, 12), das ein in Form einer biegsamen Folie (18) ausgebildetes Flächenelement (17) umfasst.

2. Anordnung (102) zum Wärmebehandeln eines Mehrschichtkörpers (1), umfassend:

     - eine Energiequelle (16, 7, 11) mit mindestens einem Heizstrahler zur Erzeugung einer Heizstrahlung (6, 8),
     - einen Mehrschichtkörper (1),
     - ein zwischen der Energiequelle (16, 7, 11) und dem Mehrschichtkörper (1) angeordnetes Zwischenelement (15, 5, 12), das ein in Form einer biegsamen Folie (18) oder starren Platte (19) ausgebildetes Flächenelement (17) umfasst, wobei das Flächenelement (17) eine der Energiequelle (16, 7, 11) zugewandte Fläche (27) aufweist, die von der Heizstrahlung (6, 8) bestrahlt werden kann, wobei die der Energiequelle (16, 7, 11) zugewandte Fläche (27) durch eine Stützeinrichtung (22, 23, 25, 26) in Richtung zur Energiequelle (16, 7, 11) mechanisch abgestützt ist.

3. Anordnung (102) zum Wärmebehandeln eines Mehrschichtkörpers nach Anspruch 1 oder 2, bei welcher die biegsame Folie (18) die folgenden Merkmale a), b) oder c) aufweist:

     a) die biegsame Folie (18) enthält Graphit oder einen Verbundwerkstoff, insbesondere kohlenstofffaserverstärkten Kohlenstoff,
     b) die biegsame Folie (18) ist eine ein- oder beidseitig mit einer Korrosionschutzschicht beschichtete Metallfolie,
     c) die biegsame Folie (18) ist eine Verbundfolie, beispielsweise eine Metallfolie, die durch einen Klebstoff ein- oder beidseitig mit einer Graphitfolie verbunden ist.

4. Anordnung (102) zum Wärmebehandeln eines Mehrschichtkörpers (1) nach Anspruch 2, bei welcher die starre Platte (19) Glaskeramik, einen Verbundwerkstoff, insbesondere kohlenstofffaserverstärkten Kohlenstoff, oder ein Glas mit einem Erweichungspunkt oberhalb von 800°C, insbesondere Borosilikatglas, Aluminosilikatglas oder Quarzglas, enthält.

5. Anordnung (102) zum Wärmebehandeln eines Mehrschichtkörpers (1) nach einem der Ansprüche 1 bis 4, bei welcher das Flächenelement (17) eine Dicke von weniger als 4 mm, vorzugsweise weniger als 1 mm, besonders bevorzugt weniger als 0,3 mm aufweist.

6. Anordnung (102) zum Wärmebehandeln eines Mehrschichtkörpers (1) nach einem der Ansprüche 1 bis 5, bei welcher das Flächenelement (17) eine Reflexion der Heizstrahlung (6, 8) von kleiner als 10%, bevorzugt kleiner als 5%, besonders bevorzugt kleiner als 2% hat.

7. Anordnung (102) zum Wärmebehandeln eines Mehrschichtkörpers (1) nach einem der Ansprüche 1 bis 6, bei welcher das Flächenelement (18) eine Strukturierung in Form von Erhebungen aufweist, die eine sich senkrecht um Flächenelement (18) bemessende Höhe von wenigen bis einigen Hundert Mikrometern aufweisen.

8. Anordnung (102) zum Wärmebehandeln eines Mehrschichtkörpers (1) nach einem der Ansprüche 2 bis 7, bei welcher die Stützeinrichtung (22) in Form eines Gitters (23, 25) aus sich kreuzenden linienförmigen Stützelementen (20, 24) oder einer Linienanordnung (26) aus nebeneinanderliegenden linienförmigen Stützelementen (20, 24) ausgebildet ist.

9. Anordnung (102) zum Wärmebehandeln eines Mehrschichtkörpers nach Anspruch 8, bei welcher die linienförmigen Stützelemente (20, 24) Metall, insbesondere ein mit einer Korrosionschutzschicht beschichtetes Metall, Graphit, Keramik, Glaskeramik, ein Glas mit einem Erweichungspunkt oberhalb von 800°C, wie Borosilikatglas, Aluminosilikatglas oder Quarzglas, oder einen Verbundwerkstoff, insbesondere einen kohlenstofffaserverstärkten Kohlenstoff, enthalten.

10. Anordnung (102) zum Wärmebehandeln eines Mehrschichtkörpers (1) nach Anspruch 8 oder 9, bei welcher die linienförmige Stützelemente (20, 24) weniger als 10%, bevorzugt weniger als 5%, noch stärker bevorzugt weniger als 2% der der der Energiequelle (16, 7, 11) zugewandten Fläche (27) des Flächenelements (17) einnehmen.

11. Anordnung (102) zum Wärmebehandeln eines Mehrschichtkörpers (1) nach einem der Ansprüche 8 bis 10, bei welcher die linienförmige Stützelemente (20, 24) teiltransparent oder transparent für die Heizstrahlung (6, 8) sind.

12. Vorrichtung (100) zum Wärmebehandeln eines Mehrschichtkörpers (1), umfassend:

    - eine Einrichtung (101) zum Ausbilden eines Prozessraums (14), welche einen Boden (5), einen Deckel (12) und mindestens einen Rahmen (13) umfasst, die gemeinsam den Prozessraum (14) zur Aufnahme des Mehrschichtkörpers (1) bilden,
    - eine benachbart zum Deckel (12) angeordnete deckelseitige Energiequelle (16, 11),
    - eine benachbart zum Boden (5) angeordnete bodenseitige Energiequelle (16, 7),
    - mindestens eine Anordnung (102) zum Wärmebehandeln eines Mehrschichtkörpers (1) nach einem der Ansprüche 1 bis 11, wobei die deckelseitige Energiequelle (16, 11), der Deckel (12) und der Mehrschichtkörper (1) eine erste Anordnung (102) zum Wärmebehandeln des Mehrschichtkörpers (1) bilden, und/oder wobei die bodenseitige Energiequelle (16, 7), der Boden (5) und der Mehrschichtkörper (1) eine zweite Anordnung (102) zum Wärmebehandeln des Mehrschichtkörpers (1) bilden.

13. Vorrichtung (100) zum Wärmebehandeln eines Mehrschichtkörpers (1) nach Anspruch 12, bei welcher in der mindestens einen Anordnung (102) zum Wärmebehandeln eines Mehrschichtkörpers (1) das Flächenelement (17) mit dem Rahmen (13) fest verbunden ist und/oder die Stützeinrichtung (22) mit dem Rahmen (13) fest verbunden ist.

14. Vorrichtung (100) zum Wärmebehandeln eines Mehrschichtkörpers (1) nach Anspruch 12, bei welcher in der ersten Anordnung (102) zum Wärmebehandeln eines Mehrschichtkörpers (1) der Rahmen (13) und/oder die Stützeinrichtung (22) mit einem ersten Rahmen (13) fest verbunden ist und in der zweiten Anordnung (102) zum Wärmebehandeln eines Mehrschichtkörpers (1) der Rahmen (13) und/oder die Stützeinrichtung (22) mit einem zweiten Rahmen (13) fest verbunden ist, wobei die beiden Rahmen (13) nicht fest miteinander verbunden sind.

15. Verfahren zum Wärmebehandeln eines Mehrschichtkörpers (1), welches umfasst:

    - Bereitstellen des Mehrschichtkörpers (1) in einer Vorrichtung (100) zum Wärmebehandeln eines Mehrschichtkörpers (1) nach einem der Ansprüche 12 bis 14,
    - Bestrahlen des Mehrschichtkörpers (1) mit auf Deckel (12) und Boden (5) gerichteten Heizstrahlungen (6,8).

FIG. 1

EP 3 690 962 A1

FIG. 2

Fig. 3

Fig. 4

Fig. 5

Fig. 6

Fig. 7

Fig. 8

Fig. 9

Fig. 10

FIG. 11

XXXXXXXXXXXXXXXXXXXXXXXXXXXXXXXXXXXX

16

A

C

B

24

21

17

Fig. 12

```
┌─────────────────────────────────────────────┐
│                                             │
│                    S1                       │
│                                             │
└─────────────────────────────────────────────┘
                       │
                       ▼
┌─────────────────────────────────────────────┐
│                                             │
│                    S2                       │
│                                             │
└─────────────────────────────────────────────┘
```

FIG. 13

**Europäisches Patentamt**
**European Patent Office**
**Office européen des brevets**

# EUROPÄISCHER RECHERCHENBERICHT

Nummer der Anmeldung

EP 19 15 4936

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 01/09961 A2 (SIEMENS AG [DE]; PROBST VOLKER [DE]) 8. Februar 2001 (2001-02-08) * Zusammenfassung *; Ansprüche 1-21; Abbildungen 1-9b * * Seite 2, Zeile 32 - Seite 23, Zeile 22 * * Seite 28, Zeile 10 - Seite 32, Zeile 26 * | 1-15 | INV. H01L31/18 H01L21/67 |
| X | JP S61 129834 A (DAINIPPON SCREEN MFG) 17. Juni 1986 (1986-06-17) * Zusammenfassung *; Ansprüche 1-9; Abbildungen 1-4 * * Absatz [0001] - Absatz [0003] * | 1-15 | |
| X | EP 0 399 662 A2 (AMERICAN TELEPHONE & TELEGRAPH [US]) 28. November 1990 (1990-11-28) * Zusammenfassung *; Ansprüche 1-14; Abbildungen 1,2 * * Spalte 3, Zeile 55 - Spalte 10, Zeile 45 * | 1-15 | |
| X | US 5 861 609 A (KALTENBRUNNER GUENTER [DE] ET AL) 19. Januar 1999 (1999-01-19) * Zusammenfassung *; Ansprüche 1-13; Abbildungen 1-3 * * Spalte 4, Zeile 30 - Spalte 7, Zeile 23 * | 1-15 | RECHERCHIERTE SACHGEBIETE (IPC) H01L |
| X | EP 2 360 720 A1 (SAINT GOBAIN [FR]) 24. August 2011 (2011-08-24) * Zusammenfassung *; Ansprüche 1-20; Abbildungen 1-7 * * Absatz [0008] - Absatz [0123] * | 1-15 | |

Der vorliegende Recherchenbericht wurde für alle Patentansprüche erstellt

| Recherchenort | Abschlußdatum der Recherche | Prüfer |
|---|---|---|
| Berlin | 15. August 2019 | Hamdani, Fayçal |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 19 15 4936

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-08-2019

| Im Recherchenbericht angeführtes Patentdokument | Datum der Veröffentlichung | Mitglied(er) der Patentfamilie | Datum der Veröffentlichung |
|---|---|---|---|
| WO 0109961 A2 | 08-02-2001 | AU 781422 B2 | 19-05-2005 |
| | | CN 1399798 A | 26-02-2003 |
| | | DE 19936081 A1 | 08-02-2001 |
| | | EP 1258043 A2 | 20-11-2002 |
| | | ES 2691644 T3 | 28-11-2018 |
| | | JP 5361106 B2 | 04-12-2013 |
| | | JP 2003519441 A | 17-06-2003 |
| | | US 6717112 B1 | 06-04-2004 |
| | | US 2004087172 A1 | 06-05-2004 |
| | | WO 0109961 A2 | 08-02-2001 |
| JP S61129834 A | 17-06-1986 | JP H0234164 B2 | 01-08-1990 |
| | | JP S61129834 A | 17-06-1986 |
| EP 0399662 A2 | 28-11-1990 | CA 2015411 A1 | 01-11-1990 |
| | | DE 69020802 D1 | 17-08-1995 |
| | | DE 69020802 T2 | 07-12-1995 |
| | | EP 0399662 A2 | 28-11-1990 |
| | | ES 2074536 T3 | 16-09-1995 |
| | | HK 100596 A | 14-06-1996 |
| | | JP H0750691 B2 | 31-05-1995 |
| | | JP H02303121 A | 17-12-1990 |
| | | KR 900019149 A | 24-12-1990 |
| | | US 5011794 A | 30-04-1991 |
| US 5861609 A | 19-01-1999 | KEINE | |
| EP 2360720 A1 | 24-08-2011 | CN 102763208 A | 31-10-2012 |
| | | EA 201290686 A1 | 28-02-2013 |
| | | EP 2360720 A1 | 24-08-2011 |
| | | EP 2539926 A1 | 02-01-2013 |
| | | JP 2013520790 A | 06-06-2013 |
| | | JP 2015156485 A | 27-08-2015 |
| | | KR 20120123097 A | 07-11-2012 |
| | | KR 20150067386 A | 17-06-2015 |
| | | US 2013067723 A1 | 21-03-2013 |
| | | WO 2011104231 A1 | 01-09-2011 |
| | | ZA 201206146 B | 24-04-2013 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **J. PALM et al.** CIS module pilot processing applying concurrent rapid selenization and sulfurization of large area thin film precursors. *Thin Solid Films,* 2003, vol. 431-432, 414-522